(19)

Europäisches
Patentamt
European
Patent Office
Office européen
des brevets

(11) **EP 4 336 480 A1**

(12) **EUROPEAN PATENT APPLICATION**
published in accordance with Art. 153(4) EPC

(43) Date of publication:
**13.03.2024 Bulletin 2024/11**

(21) Application number: **22882714.3**

(22) Date of filing: **12.10.2022**

(51) International Patent Classification (IPC):
***G09F 9/33*** (2006.01)

(52) Cooperative Patent Classification (CPC):
**G09F 9/33; H10K 59/12; H10K 59/131**

(86) International application number:
**PCT/CN2022/124814**

(87) International publication number:
**WO 2023/066104 (27.04.2023 Gazette 2023/17)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **20.10.2021 CN 202111221399**

(71) Applicants:
- **BOE Technology Group Co., Ltd.
Chaoyang District,
Beijing 100015 (CN)**
- **Chengdu BOE Optoelectronics Technology Co.,
Ltd.
Chengdu, Sichuan 611731 (CN)**

(72) Inventors:
- **LIU, Changchang
Beijing 100176 (CN)**
- **FANG, Fei
Beijing 100176 (CN)**
- **LU, Hongting
Beijing 100176 (CN)**
- **LI, Shuo
Beijing 100176 (CN)**
- **HU, Yao
Beijing 100176 (CN)**

(74) Representative: **Durán-Corretjer, S.L.P.
Còrsega, 329
(Paseo de Gracia/Diagonal)
08037 Barcelona (ES)**

(54) **DISPLAY SUBSTRATE AND DISPLAY DEVICE**

(57)      A display substrate, comprising: a base substrate (100), multiple first pixel circuits (11), multiple first light-emitting elements (12), and at least one first signal line (L1). The multiple first pixel circuits (11) and the multiple first light-emitting elements (12) are located in a first display area (A1). At least one first pixel circuit (11) is electrically connected to at least one first light-emitting element (12), and is configured to drive the at least one first light-emitting element (12) to emit light. The at least one first signal line (L1) is configured to provide, in a first direction (X), a first signal for the multiple first pixel circuits (11). The at least one first signal (L1) comprises a first sub-signal line (L11) and a second sub-signal line (L12) that are electrically connected in parallel, the first sub-signal line (L11) is located in the first display area (A1), and the second sub-signal line (L12) is located in a second display area (A2).

FIG. 4

**Description**

The present application claims priority to Chinese Patent Application No. 202111221399.2, filed to the CNIPA on October 20, 2021 and entitled "Display Substrate and Display Apparatus", the content of which should be regarded as being incorporated herein by reference.

Technical Field

The present disclosure relates to, but is not limited to, the field of display technologies, and in particular to a display substrate and a display apparatus.

Background

An Organic Light Emitting Diode (OLED) and a Quantum dot Light Emitting Diode (QLED) are active light emitting display devices and have advantages of self-luminescence, a wide viewing angle, a high contrast ratio, low power consumption, an extremely high response speed, lightness and thinness, bendability, and low cost, etc. With continuous development of display technologies, a camera is usually installed on a display device to meet shooting needs.

Summary

The following is a summary of subject matter described herein in detail. The summary is not intended to limit the protection scope of claims.

Embodiments of the present disclosure provide a display substrate and a display apparatus.

In one aspect, an embodiment of the present disclosure provides a display substrate including a base substrate, a plurality of first pixel circuits, a plurality of first light emitting elements, and at least one first signal line. The base substrate includes a first display region and a second display region located on at least one side of the first display region. The plurality of first pixel circuits and the plurality of first light emitting elements are located in the first display region. At least one first pixel circuit among the plurality of first pixel circuits is electrically connected with at least one first light emitting element among the plurality of first light emitting elements, and is configured to drive the at least one first light emitting element to emit light. The at least one first signal line is configured to provide a first signal to the plurality of first pixel circuits in a first direction. The at least one first signal line includes a first sub-signal line and a second sub-signal line connected in parallel and electrically, wherein the first sub-signal line is located in the first display region, and the second sub-signal line is located in the second display region.

In some exemplary implementation modes, the first sub-signal line is made of a transparent conductive material, and the second sub-signal line is made of a metal material.

In some exemplary implementation modes, the second sub-signal line is located on a side of the first sub-signal line away from the base substrate.

In some exemplary implementation modes, the at least one first signal line further includes a third sub-signal line and a fourth sub-signal line located in the second display region, wherein the third sub-signal line and the fourth sub-signal line are located within the second display region on opposite sides of the first display region along the first direction. Both ends of the first sub-signal line are electrically connected with the third sub-signal line and the fourth sub-signal line, respectively, and both ends of the second sub-signal line are electrically connected with the third sub-signal line and the fourth sub-signal line, respectively.

In some exemplary implementation modes, at least one end of the first sub-signal line is electrically connected with the third sub-signal line or the fourth sub-signal line through a gate of a transistor of at least one first pixel circuit.

In some exemplary implementation modes, the display substrate includes a plurality of first signal lines, and the plurality of first signal lines are divided into two groups, wherein a second sub-signal line of a first group of first signal lines is located within the second display region on one side of the first display region along a second direction, a second sub-signal line of a second group of first signal lines is located within the second display region on the other side of the first display region along the second direction, and the second direction intersects with the first direction.

In some exemplary Implementation modes, the display substrate further includes a plurality of second pixel circuits and a plurality of second light emitting elements located in the second display region, wherein at least one second pixel circuit among the plurality of second pixel circuits is electrically connected with at least one second light emitting element among the plurality of second light emitting elements, and is configured to drive the at least one second light emitting element to emit light. An orthographic projection of a second sub-signal line of the at least one first signal line on the base substrate is not overlapped with an orthographic projection of an anode of the second light emitting element on the base substrate.

In some exemplary implementation modes, the second pixel circuit at least includes a drive transistor, a threshold compensation transistor, and a storage capacitor. A gate of the drive transistor is electrically connected with a first electrode plate of the storage capacitor and a first electrode of the threshold compensation transistor. An orthographic projection of the second sub-signal line of the at least one first signal line on base substrate is not overlapped with an orthographic projection of a connection position of the gate of the drive transistor, the first electrode of the threshold compensation transistor, and the first electrode plate of the storage capacitor of the second pixel circuit on the base substrate.

In some exemplary implementation modes, the second sub-signal line includes a first connection segment, a second connection segment, a third connection segment, and a fourth connection segment. The second connection segment is a straight line segment extending along the first direction, the second connection segment is electrically connected with the first connection segment, and the first connection segment is configured to at least partially surround an anode of one second light emitting element. The third connection segment is a fold line extending along a second direction, the fourth connection segment is connected with the third connection segment, and the fourth connection segment is a straight line segment extending along the first direction, wherein the second direction intersects with the first direction.

In some exemplary implementation modes, the second display region is further provided with a plurality of auxiliary traces disposed in a same layer as the second sub-signal lines, and an orthographic projection of the plurality of auxiliary traces on the base substrate is not overlapped with the orthographic projection of the anode of the second light emitting element or the orthographic projection of the connection position of the gate of the drive transistor, the first electrode of the threshold compensation transistor, and the first electrode plate of the storage capacitor of the second pixel circuit on the base substrate.

In some exemplary implementation modes, the auxiliary traces are configured to be electrically connected with a first power supply line.

In some exemplary implementation modes, at least one of the plurality of auxiliary traces includes a first auxiliary segment and a second auxiliary segment which are connected with each other, wherein the first auxiliary segment is a straight line segment extending along the first direction, the second auxiliary segment is a fold line extending along a second direction, and the second direction intersects with the first direction.

In some exemplary Implementation modes, the at least one first signal line includes at least one of following: a scan line, a first reset control line, and a light emitting control line.

In some exemplary implementation modes, the display substrate further includes at least one second signal line configured to provide a second signal to the plurality of first pixel circuits in a second direction. The at least one second signal line includes a fifth sub-signal line and a sixth sub-signal line connected in parallel and electrically, wherein the fifth sub-signal line is located in the first display region and the sixth sub-signal line is located in the second display region; the first direction intersects with the second direction.

In an exemplary implementation, the first direction is perpendicular to the second direction.

In some exemplary implementation modes, the at least one second signal line further includes a seventh sub-signal line and an eighth sub-signal line located in the second display region, wherein the seventh sub-signal line and the eighth sub-signal line are located within the second display region on opposite sides of the first display region along the second direction. Both ends of the fifth sub-signal line are electrically connected with the seventh sub-signal line and the eighth sub-signal line, respectively, and both ends of the sixth sub-signal line are electrically connected with the seventh sub-signal line and the eighth sub-signal line, respectively.

In some exemplary implementation modes, the fifth sub-signal line is disposed in a same layer as the first sub-signal line, and the sixth sub-signal line and the second sub-signal line are located in different film layers.

In some exemplary implementation modes, a pixel density of the first display region is less than or equal to a pixel density of the second display region.

In some exemplary implementation modes, a light transmission rate of the first display region is greater than a light transmission rate of the second display region.

In another aspect, an embodiment of the present disclosure provides a display apparatus, which includes the aforementioned display substrate.

Other aspects may be understood upon reading and understanding accompanying drawings and detailed description.

Brief Description of Drawings

The accompanying drawings are used for providing further understanding of technical solutions of the present disclosure, constitute a part of the specification, and are used for explaining the technical solutions of the present disclosure together with the embodiments of the present disclosure, but do not constitute limitations on the technical solutions of the present disclosure. Shapes and sizes of one or more components in the drawings do not reflect actual scales, and are only intended to schematically describe contents of the present disclosure.

FIG. 1 is a schematic diagram of a display substrate according to at least one embodiment of the present disclosure.

FIG. 2 is an equivalent circuit diagram of a pixel circuit according to at least one embodiment of the present disclosure.

FIG. 3 is a working timing diagram of the pixel circuit provided in FIG. 2.

FIG. 4 is a partial schematic diagram of a first signal line of a display substrate according to at least one embodiment of the present disclosure.

FIG. 5 and FIG. 6 are partial trace schematic diagrams of a display substrate according to at least one embodiment of the present disclosure.

FIG. 7 is a partial plan schematic diagram of a display region according to at least one embodiment of the present disclosure.

FIG. 8 is a partial plan schematic diagram of a region A11 in FIG. 7.

FIG. 9 is a partial cross-sectional schematic diagram along a Q-Q' direction in FIG. 8.

FIG. 10 is a partial plan schematic diagram of a region A12 in FIG. 7.

FIG. 11 is a partial plan schematic diagram of a region A13 in FIG. 7.

FIG. 12A is a partial schematic diagram of a first display region after a semiconductor layer is formed in FIG. 8.

FIG. 12B is a partial schematic diagram of a second display region after a semiconductor layer is formed in FIG. 10.

FIG. 12C is a partial schematic diagram of a display region after a semiconductor layer is formed in FIG. 11.

FIG. 13A is a partial schematic diagram of a first display region after a first conductive layer is formed in FIG. 8.

FIG. 13B is a partial schematic diagram of a second display region after a first conductive layer is formed in FIG. 10.

FIG. 13C is a partial schematic diagram of a display region after a first conductive layer is formed in FIG. 11.

FIG. 14A is a partial schematic diagram of a first display region after a second conductive layer is formed in FIG. 8.

FIG. 14B is a partial schematic diagram of a second display region after a second conductive layer is formed in FIG. 10.

FIG. 14C is a partial schematic diagram of a display region after a second conductive layer is formed in FIG. 11.

FIG. 15A is a partial schematic diagram of a first display region after a third insulation layer is formed in FIG. 8.

FIG. 15B is a partial schematic diagram of a second display region after a third insulation layer is formed in FIG. 10.

FIG. 15C is a partial schematic diagram of a display region after a third insulation layer is formed in FIG. 11.

FIG. 16A is a partial schematic diagram of a first display region after a third conductive layer is formed in FIG. 8.

FIG. 16B is a partial schematic diagram of a second display region after a third conductive layer is formed in FIG. 10.

FIG. 16C is a partial schematic diagram of a display region after a third conductive layer is formed in FIG. 11.

FIG. 17A is a partial schematic diagram of a first display region after a fourth insulation layer is formed in FIG. 8.

FIG. 17B is a partial schematic diagram of a display region after a fourth insulation layer is formed in FIG. 11.

FIG. 18A is a partial schematic diagram of a first display region after a transparent conductive layer is formed in FIG. 8.

FIG. 18B is a partial schematic diagram of a display region after a transparent conductive layer is formed in FIG. 11.

FIG. 19A is a partial schematic diagram of a first display region after a fifth insulation layer is formed in FIG. 8.

FIG. 19B is a partial schematic diagram of a second display region after a fifth insulation layer is formed in FIG. 10.

FIG. 19C is a partial schematic diagram of a display region after a fifth insulation layer is formed in FIG. 11.

FIG. 20A is a partial schematic diagram of a first display region after a fourth conductive layer is formed in FIG. 8.

FIG. 20B is a partial schematic diagram of a second display region after a fourth conductive layer is formed in FIG. 10.

FIG. 21 is a schematic diagram of an anode layer and a fourth conductive layer in FIG. 10.

FIG. 22 is a schematic diagram of a trace at a junction of a first display region and a second display region according to at least one embodiment of the present disclosure.

FIG. 23 is a partial schematic diagram of a second signal line of a display substrate according to at least one embodiment of the present disclosure.

FIG. 24 is a partial schematic diagram of a first signal line and a second signal line of a display substrate according to at least one embodiment of the present disclosure.

FIG. 25 is a schematic diagram of a display apparatus according to at least one embodiment of the present disclosure.

Detailed Description

The embodiments of the present disclosure will be described below with reference to the drawings in detail. Implementation modes may be implemented in a plurality of different forms. Those of ordinary skills in the art may easily understand such a fact that modes and contents may be transformed into other forms without departing from the purpose and scope of the present disclosure. Therefore, the present disclosure should not be explained as being limited to contents described in following implementation modes only. The embodiments in the present disclosure and features in the embodiments may be combined randomly with each other if there is no conflict.

In the drawings, a size of one or more constituent elements, a thickness of a layer, or a region is sometimes exaggerated for clarity. Therefore, one mode of the present disclosure is not necessarily limited to the size, and a shape and a size of one or more components in the drawings do not reflect an actual scale. In addition, the drawings schematically illustrate ideal examples, and one mode of the present disclosure is not limited to shapes, numerical values, or the like shown in the drawings.

Ordinal numerals such as "first", "second", and "third" in the specification are set to avoid confusion between constituent elements, but not to set a limit in quantity. In the present disclosure, "plurality" represents two or more than two.

In the specification, for convenience, wordings indicating orientation or positional relationships, such as "middle", "upper", "lower", "front", "back", "vertical", "horizontal", "top", "bottom", "inside", and "outside", are used for illustrating positional relationships between constituent elements with reference to the drawings, and are merely for facilitating the description of the specification and simplifying the description, rather than indicating or implying that a referred apparatus or element must have a particular orientation and be constructed and operated in the particular orientation. Therefore, they cannot be understood as limitations on the present disclosure. The positional relationships between the constituent elements are changed as appropriate according to a direction where the constituent elements are described. Therefore, appropriate replacements may be made according to situations without being limited to the wordings described in the specification.

In the specification, unless otherwise specified and defined explicitly, terms "mount", "mutually connect", and "connect" should be understood in a broad sense. For example, it may be a fixed connection, a detachable connection, or an integrated connection; it may be a mechanical connection or a connection; it may be a direct connection, an indirect connection through an intermediate component, or communication inside two components. Those of ordinary skills in the art may understand meanings of the above-mentioned terms in the present disclosure according to situations.

In the specification, an "electrical connection" includes a case that constituent elements are connected together through an element having some electrical function. The "element having some electrical function" is not particularly limited as long as electrical signals between the connected constituent elements may be transmitted. Examples of the "element having some electrical function" not only include an electrode and a wiring, but also include a switching element such as a transistor, a resistor, an inductor, a capacitor, and another element with a plurality of functions, etc.

In the specification, a transistor refers to an element which at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. In the specification, the channel region refers to a region through which a current mainly flows.

In the specification, a first electrode may be a drain electrode and a second electrode may be a source electrode, or, the first electrode may be a source electrode and the second electrode may be a drain electrode. In a case that transistors with opposite polarities are used, or in a case that a direction of a current is changed during operation of a circuit, or the like, functions of the "source electrode" and the "drain electrode" are sometimes interchangeable. Therefore, the "source electrode" and the "drain electrode" are interchangeable in the specification.

In the specification, "parallel" refers to a state in which an angle formed by two straight lines is above -10° and below 10°, and thus also includes a state in which the angle is above -5° and below 5°. In addition, "perpendicular" refers to a state in which an angle formed by two straight lines is above 80° and below 100°, and thus also includes a state in which the angle is above 85° and below 95°.

A "light transmission rate" in the present disclosure refers to an ability of light passing through a medium, and is a percentage of luminous flux passing through a transparent or translucent body to its incident luminous flux.

In the present disclosure, "about" and "substantially" refer to that a boundary is not defined strictly and a case within a range of a process and measurement error is allowed. In the present disclosure, "substantially the same" refers to a case where numerical values differ by less than 10%.

In the present specification, "A extends along a B direction" means that A may include a main body portion and a secondary portion connected with the main body portion, the main body portion is a line, a line segment, or a strip-shaped body, the main body portion extends along the B direction, and a length of the main body portion extending along the B direction is greater than a length of the secondary portion extending along another direction. "A extends along a B direction" in the present specification means "a main portion of A extends along a B direction".

An embodiment of the present disclosure provides a display substrate, including a base substrate, a plurality of first pixel circuits, a plurality of first light emitting elements, and at least one first signal line. The base substrate includes a first display region and a second display region located on at least one side of the first display region. The plurality of first pixel circuits and the plurality of first light emitting elements are located in the first display region. At least one first pixel circuit is electrically connected with at least one first light emitting element, and is configured to drive the at least one first light emitting element to emit light. At least one first signal line is configured to provide a first signal to a plurality of first pixel circuits in a first direction. At least one first signal line includes a first sub-signal line and a second sub-signal line which are connected in parallel and electrically. At least part of the first sub-signal line is located in the first display region, and the second sub-signal line is located in the second display region.

In this embodiment, a parallel connection is referred to as a connection mode in which at least two elements of a same kind or different kinds are connected in parallel between two points of a circuit. In this example, the first sub-signal line may have a first end and a second end, and the second sub-signal line may have a first end and a second end. The first sub-signal line and the second sub-signal line are connected in parallel, which means that the first end of the first sub-signal line and the first end of the second sub-signal line are electrically connected, the second end of the first sub-signal line and the second end of the second sub-signal line are electrically connected, and the first sub-signal line and the second sub-signal line are connected in parallel to a transmission circuit of the first signal.

According to the display substrate provided by an embodiment, an influence of an impedance of the first signal line on the first display region may be improved by disposing the first signal line to transmit the first signal to the first display region in a parallel trace mode, thereby improving a refresh rate and a uniform display effect of the display substrate.

In some exemplary implementation modes, the first sub-signal line may be made of a transparent conductive material such as Indium Tin Oxide (ITO) or the like, and the second sub-signal line may be made of a metal material. The first sub-signal line is made of the transparent conductive material, which can ensure a light transmittance rate of the first display region. Since a resistance of the transparent conductive material is greater than that of a metal material, the second sub-signal line made of the metal material and the first sub-signal line made of the transparent conductive material are connected in parallel and electrically in this example, which may improve display mura in the second display region around the first display region due to an excessive resistance of the first sub-signal line, so that the refresh rate of the display substrate and the uniform display effect may be improved.

In some exemplary implementation modes, the second sub-signal line may be located on a side of the first sub-signal line away from the base substrate. However, this embodiment is not limited thereto. In other examples, the second sub-signal line may be located on a side of the first sub-signal line close to the base substrate.

In some exemplary implementation modes, the display substrate may further include a plurality of second pixel circuits and a plurality of second emitting light elements located in the second display region. At least one second pixel circuit among the plurality of second pixel circuits is electrically connected with at least one second light emitting element among the plurality of second light emitting elements, and is configured to drive the at least one second light emitting element to emit light. An orthographic projection of a second sub-signal line of at least one first signal line on the base substrate is not overlapped with an orthographic projection of an anode of a second light emitting element on the base substrate. By setting an arrangement that a second sub-signal line of a first signal line bypasses an anode of a second light emitting element in this example, flatness of the second light emitting element may be ensured, thereby ensuring a display effect of the second light emitting element.

In some exemplary implementation modes, a second pixel circuit may at least include a drive transistor, a threshold compensation transistor, and a storage capacitor. A gate of the drive transistor is electrically connected with a first electrode plate of the storage capacitor and a first electrode of the threshold compensation transistor. An orthographic projection of a second sub-signal line of at least one first signal line on the base substrate is not overlapped with an orthographic projection of a connection position of the gate of the drive transistor of the second pixel circuit, the first electrode of the threshold compensation transistor, and the first electrode plate of the storage capacitor on the base substrate. In this example, a connection point of the gate of the drive transistor, the first electrode of the threshold compensation transistor, and the first electrode plate of the storage capacitor of the second pixel circuit is a first node, and crosstalk of a first signal transmitted by a first signal line to the first node may be reduced by setting a second sub-signal line of the first signal line to avoid the first node.

In some exemplary implementation modes, the second display region may further include a plurality of auxiliary traces disposed in a same layer as second sub-signal lines. An orthographic projection of the plurality of auxiliary traces on the base substrate may not be overlapped with an orthographic projection of an anode of a second light emitting element on the base substrate, and may also not be overlapped with an orthographic projection of the connection position of the gate of the drive transistor, the first electrode of the threshold compensation transistor, and the first electrode of the storage capacitor of the second pixel circuit on the base substrate. In this example, the auxiliary traces similar to an arrangement of the second sub-signal lines are disposed and the auxiliary traces bypass the anode of the second light emitting element and the first node of the second pixel circuit, so that uniformity of traces in the display region may be ensured, a display effect of the second light emitting element may be ensured, and crosstalk to the first node may be reduced.

In some exemplary implementation modes, an auxiliary trace may be configured to be electrically connected with a first power supply line. In this way, display uniformity of the display substrate may be improved.

In some exemplary implementation modes, the display substrate may further include at least one second signal line configured to provide a second signal to the plurality of first pixel circuits in a second direction. At least one second signal line may include a fifth sub-signal line and a sixth sub-signal line connected in parallel and electrically, the fifth sub-signal line may be located in the first display region, and the sixth sub-signal line may be located in the second display region. The first direction intersects with the second direction. For example, the first direction may be perpendicular to the second direction. In the example, an influence of an impedance of the second signal line on the first display region may be improved by setting the second signal line to transmit the second signal to the first display region in a parallel trace mode, thereby improving a refresh rate and a uniform display effect of the display substrate.

Solutions of the embodiments will be described below through some examples.

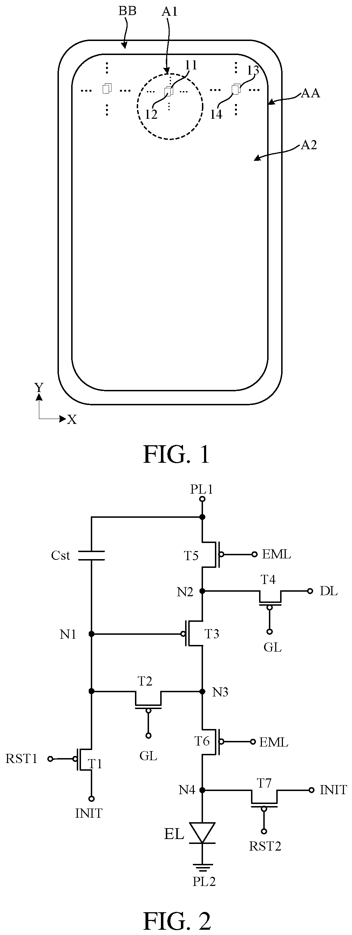

FIG. 1 is a schematic diagram of a display substrate according to at least one embodiment of the present disclosure. In some examples, as shown in FIG. 1, the display substrate may include a display region AA and a peripheral region BB located at a periphery of the display region AA. The display region AA of the display substrate may include a first display region A1 and a second display region A2 located on at least one side of the first display region A1. For Example, the second display region A2 may surround the first display region A1. The first display region A1 may be located at a top middle position of the display region AA. However, this embodiment is not limited thereto. For example, the first display region A1 may be located at another position such as an upper left corner or an upper right corner of the display region AA.

In some examples, as shown in FIG. 1, the display region AA may have a shape of a rectangle, e.g., a rounded rectangle. The first display region A1 may be circular or oval. However, this embodiment is not limited thereto. For example, the first display region A1 may be rectangular, pentagonal, hexagonal, or have another shape.

In some examples, as shown in FIG. 1, the first display region A1 may be a light transmitting display region and may also be referred to as a Full Display with Camera (FDC) region. The second display region A2 may be a non-light transmitting display region, and may also be referred to as a normal display region. A light transmittance rate of the first display region A1 may be greater than a light transmittance rate of the second display region A2. For example, an orthographic projection of hardware such as a photosensitive sensor (such as a camera and, an infrared sensor) on the display substrate may be located within the first display region A1 of the display substrate. In some examples, the first display region A1 may be circular and a size of the orthographic projection of the photosensitive sensor on the display substrate may be less than or equal to a size of the first display region A1. However, this embodiment is not limited thereto. In other examples, the first display region may be rectangular, and the size of the orthographic projection of the photosensitive sensor on the display substrate may be less than or equal to a size of an inscribed circle of the first display region.

In some examples, the display region AA may at least include a plurality of pixel units arranged regularly, a plurality of first signal lines (for example, including a scanline, a reset control line, and a light emitting control line) extending along a first direction X, a plurality of second signal lines (for example, including a data line and a power supply line) extending along a second direction Y. among them, the first direction X and the second direction Y may be located within a same plane, and the first direction X intersects with the second direction Y, for example, the first direction X may be perpendicular to the second direction Y.

In some examples, one pixel unit of the display region may include three sub-pixels, which may be a red sub-pixel, a green sub-pixel, and a blue sub-pixel respectively. However, this embodiment is not limited thereto. In some examples, one pixel unit may include four sub-pixels, which may be a red sub-pixel, a green sub-pixel, a blue sub-pixel, and a white sub-pixel respectively.

In some examples, at least one sub-pixel may include a pixel circuit and a light emitting element. The pixel circuit may be configured to drive a light emitting element connected with the pixel circuit. For example, the pixel circuit may be configured to provide a drive current for driving the light emitting element to emit light. The pixel circuit may include a plurality of transistors and at least one capacitor. For example, the pixel circuit may have a 3T1C structure, an 8T1C structure, a 7T1C structure, or a 5T1C structure, wherein T in the above circuit structure refers to a thin film transistor, C refers to a capacitor, a number before T represents a quantity of thin film transistors in the circuit, and a number before C represents a quantity of capacitors in the circuit.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under drive of its corresponding pixel circuit. A color of light emitted from the light emitting element may be determined as required. In some examples, the light emitting element may include an anode, a cathode, and an organic emitting layer disposed between the anode and the cathode. The anode of the light emitting element may be electrically connected with the corresponding pixel circuit. However, this embodiment is not limited thereto.

In some examples, a shape of the light emitting element may be a rectangle, a rhombus, a pentagon, or a hexagon. When a pixel unit includes three sub-pixels, light emitting elements of the three sub-pixels may be arranged side by side horizontally, side by side vertically, or in a manner like a Chinese character "品". When a pixel unit includes four sub-pixels, light emitting elements of the four sub-pixels may be arranged side by side horizontally, side by side vertically, or in a manner to form a square. However, this embodiment is not limited thereto.

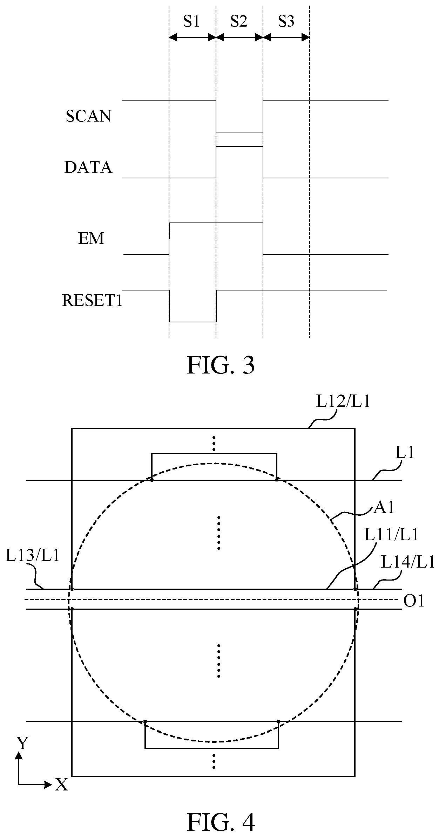

FIG.2 is an equivalent circuit diagram of a pixel circuit according to at least one embodiment of the present disclosure. The pixel circuit of this example is described by taking a 7T1C structure as an example. FIG.3 is a working timing diagram of the pixel circuit provided in FIG.2.

In some examples, as shown in FIG.2, the pixel circuit of this example may include six switching transistors (T1, T2, and T4 to T7), one drive transistor T3, and one storage capacitor Cst. The six switching transistors are respectively a data writing transistor T4, a threshold compensation transistor T2, a first light emitting control transistor T5, a second light emitting control transistor T6, a first reset transistor T1, and a second reset transistor T7. A light emitting element EL includes an anode, a cathode, and an organic emitting layer disposed between the anode and the cathode.

In some examples, the drive transistor and the six switching transistors may be P-type transistors or may be N-type transistors. Using a same type of transistors in a pixel circuit may simplify a process flow, reduce a process difficulty of a display substrate, and improve a yield of products. In some exemplary Implementation modes, the drive transistor and the six switching transistors may include a P-type transistor and an N-type transistor.

In some examples, Low Temperature Poly Silicon thin film transistors, or oxide thin film transistors, or a Low Temperature Poly Silicon thin film transistor and an oxide thin film transistor may be adopted for the drive transistor and the six switching transistors. An active layer of a Low Temperature Poly Silicon thin film transistor is made of Low Temperature Poly Silicon (LTPS), and an active layer of an oxide thin film transistor is made of an oxide semiconductor (Oxide). A Low-temperature Poly Silicon thin film transistor has advantages such as a high mobility rate and fast charging, and an oxide thin film transistor has advantages such as a low leakage current. The Low Temperature Poly Silicon thin film transistor and the oxide thin film transistor are integrated on one display substrate to form a Low Temperature Polycrystalline Oxide (LTPS + Oxide) display substrate, and advantages of both the Low Temperature Poly Silicon thin film transistor and the oxide thin film transistor may be utilized, which may achieve low frequency drive, reduce power consumption, and improve display quality.

In some examples, as shown in FIG. 2, a pixel circuit may be connected with a scan line GL, a data line DL, a first power supply line PL1, a second power supply line PL2, a light emitting control line EML, an initial signal line INIT, a first reset control line RST1, and a second reset control line RST2. In some examples, the first power supply line PL1 may be configured to provide a constant first voltage signal VDD to the pixel circuit, the second power supply line PL2 may be configured to provide a constant second voltage signal VSS to the pixel circuit, wherein the first voltage signal VDD is greater than the second voltage signal VSS. The scan line GL may be configured to provide a scan signal SCAN to the pixel circuit, the data line DL may be configured to provide a data signal DATA to the pixel circuit, the light emitting control line EML may be configured to provide a light emitting control signal EM to the pixel circuit, the first reset control line RST1 may be configured to provide a first reset control signal RESET 1 to the pixel circuit, and the second reset control line RST2 may be configured to provide a second reset signal RESET2 to the pixel circuit.

In some examples, in a row of pixel circuits, a second reset control line RST2 may be connected with a scan line GL to be input with a scan signal SCAN. That is, a second reset signal RESET2(n) received by a pixel circuit of an n-th row is a scan signal SCAN(n) received by the pixel circuit of the n-th row, wherein n is a positive integer. However, this embodiment is not limited thereto. For example, the second reset control signal line RST2 may be inputted with a second reset control signal RESET2 different from the scan signal SCAN. In some examples, in a pixel circuit of an n-th row, a first reset control line RST1 may be connected with a scan line GL of a pixel circuit of an (n-1)-th row to be inputted with a scan signal SCAN(n-1), that is, a first reset control signal RESET1(n) is the same as the scan signal SCAN(n-1). In this way, signal lines of the display substrate may be reduced, and a narrow bezel of the display substrate may be achieved.

In some examples, as shown in FIG. 2, the drive transistor T3 is electrically connected with the light emitting element EL, and outputs a drive current to drive the light emitting element EL to emit light under control of the scan signal SCAN, the data signal DATA, the first voltage signal VDD, and the second voltage signal VSS, etc. A gate of the data writing transistor T4 is electrically connected with a scan line GL, a first electrode of the data writing transistor T4 is electrically connected with a data line DL, and a second electrode of the data writing transistor T4 is electrically connected with a first electrode of the drive transistor T3. A gate of the threshold compensation transistor T2 is electrically connected with a scan line GL, a first electrode of the threshold compensation transistor T2 is electrically connected with a gate of the drive transistor T3, and a second electrode of the threshold compensation transistor T2 is electrically connected with a second electrode of the drive transistor T3. A gate of the first light emitting control transistor T5 is electrically connected with a light emitting control line EML, a first electrode of the first light emitting control transistor T5 is electrically connected with a first power supply line PL1, and a second electrode of the first light emitting control transistor T5 is electrically connected with the first electrode of the drive transistor T3. A gate of the second light emitting control transistor T6 is electrically connected with a light emitting control line EML, a first electrode of the second light emitting control transistor T6 is electrically connected with the second electrode of the drive transistor T3, and a second electrode of the second light emitting control transistor T6 is electrically connected with an anode of the light emitting element EL. The first reset transistor T1 is electrically connected with the gate of the drive transistor T3 and configured to reset the gate of the drive transistor T3, and the second reset transistor T7 is electrically connected with the anode of the light emitting element EL and configured to reset the anode of the light emitting element EL. A gate of the first reset transistor T1 is electrically connected with a first reset control line RST1, a first electrode of the first reset transistor T1 is electrically connected with an initial signal line INIT, and a second electrode of the first reset transistor T1 is electrically connected with the gate of the drive transistor T3. A gate of the second reset transistor T7 is electrically connected with a second reset control line RST2, a first electrode of the second reset transistor T7 is electrically connected with an initial signal line INIT, and a second electrode of the second reset transistor T7 is electrically connected with the anode of the light emitting element EL. A first electrode plate of the storage capacitor Cst is electrically connected with the gate of the drive transistor T3, and a second electrode plate of the storage capacitor Cst is electrically connected with the first power supply line PL1.

In this example, a first node N1 is a connection point of the storage capacitor Cst, the first reset transistor T1, the drive transistor T3, and the threshold compensation transistor T2, a second node N2 is a connection point of the first light emitting control transistor T5, the data writing transistor T4, and the drive transistor T3, a third node N3 is a connection point of the drive transistor T3, the threshold compensation transistor T2, and the second light emitting control transistor T6, and a fourth node N4 is a connection point of the second light emitting control transistor T6, the second reset transistor T7, and the light emitting element EL.

A working process of the pixel circuit shown in FIG. 2 will be described below with reference to FIG. 3. among them, description is given by taking a case in which a plurality of transistors included in the pixel circuit shown in FIG. 2 are all P-type transistors as an example. In this example, a second reset control line RST2 may be connected with a scan line GL to be input with a scan signal SCAN.

In some examples, as shown in FIG. 2 and FIG. 3, during one frame display time period, the working process of the pixel circuit may include a first stage S1, a second stage S2, and a third stage S3.

The first stage S1 is referred to as a reset stage. A first reset control signal RESET1 provided by the first reset control line RST1 is a low-level signal, so that the first reset transistor T1 is turned on, and an initial signal Vinit provided by the initial signal line INIT is provided to the first node N1 to initialize the first node N1 and clear an original data voltage in the storage capacitor Cst. A scan signal SCAN provided by the scan line GL is a high-level signal, and a light emitting control signal EM provided by the light emitting control line EML is a high-level signal, so that the data writing transistor T4, the threshold compensation transistor T2, the first light emitting control transistor T5, the second light emitting control transistor T6, and the second reset transistor T7 are turned off. In this stage, the light emitting element EL does not emit light.

The second stage S2 is referred to as a data writing stage or a threshold compensation stage. A scan signal SCAN provided by the scan line GL is a low-level signal, a first reset control signal RESET1 provided by the first reset control line RST1 and a light emitting control signal EM provided by the light emitting control line EML are both high-level signals, and the data line DL outputs a data signal DATA. In this stage, since the second electrode of the storage capacitor Cst is at a low level, the drive transistor T3 is turned on. The scan signal SCAN is a low-level signal, so that the threshold compensation transistor T2, the data writing transistor T4, and the second reset transistor T7 are turned on. The threshold compensation transistor T2 and the data writing transistor T4 are turned on, so that a data voltage Vdata output by the data line DL is provided to the first node N2 through the second node N2, the turned-on drive transistor T3, the third node N3, and the turned-on threshold compensation transistor T2, and the storage capacitor Cst is charged with a difference between the data voltage Vdata output by the data line DL and a threshold voltage of the drive transistor T3. A voltage of the second electrode (that is, the first node N1) of the storage capacitor Cst is Vdata-IVthI, wherein Vdata is the data voltage output by the data line DL, and Vth is the threshold voltage of the drive transistor T3. The second reset transistor T7 is turned on, so that an initial signal Vinit provided by the initial signal line INIT is provided to the anode of the light emitting element EL to initialize (reset) the anode of the light emitting element EL and clear a pre-stored voltage therein, so as to complete initialization, thereby ensuring that the light emitting element EL does not emit light. The first reset control signal RESET 1 provided by the first reset control line RST1 is a high-level signal, so that the first reset transistor T1 is turned off. The light emitting control signal EM provided by the light emitting control signal line EML is a high-level signal, so that the first light emitting control transistor T5 and the second light emitting control transistor T6 are turned off.

The third stage S3 is referred to as a light emitting stage. A light emitting control signal EM provided by the light emitting control signal line EML is a low-level signal, and a scan signal SCAN provided by the scan line GL and a first reset control signal RESET1 provided by the first reset control line RST1 are high-level signals. The light emitting control signal EM provided by the light emitting control signal line EML is the low-level signal, so that the first light emitting control transistor T5 and the second light emitting control transistor T6 are turned on, and a first voltage signal VDD output by the first power supply line PL1 provides a drive voltage to the anode of the light emitting element EL through the turned-on first light emitting control transistor T5, the drive transistor T3, and the second light emitting control transistor T6 to drive the light emitting element EL to emit light.

In a drive process of the pixel circuit, a drive current flowing through the drive transistor T3 is determined by a voltage difference between the gate and the first electrode of the drive transistor T3. Since the voltage of the first node N1 is Vdata-IVthI, the drive current of the drive transistor T3 is as follows.

$$I = K \times (Vgs-Vth)^2 = K \times [(VDD-Vdata+|Vth|)-Vth]^2 = K \times [(VDD-Vdata)]^2$$

Among them, I is the drive current flowing through the drive transistor T3, that is, a drive current for driving the light emitting element EL; K is a constant; Vgs is the voltage difference between the gate and the first electrode of the drive transistor T3; Vth is the threshold voltage of the drive transistor T3; Vdata is the data voltage output by the data line DL; and VDD is the first voltage signal output by the first power supply line PL1.

It may be seen from the above formula that a current flowing through the light emitting element EL has nothing to do with the threshold voltage of the drive transistor T3. Therefore, the pixel circuit of this embodiment may better compensate the threshold voltage of the drive transistor T3.

In some examples, as shown in FIG. 1, the first display region A1 of the display substrate may be provided with a plurality of first light emitting elements 12 and a plurality of first pixel circuits 11. At least one first pixel circuit 11 is electrically connected with at least one first light emitting element 12, and is configured to drive the at least one first light emitting element 12 to emit light. An orthographic projection of the first pixel circuit 11 on the base substrate may be at least partially overlapped with an orthographic projection of the first light emitting element 12 connected electrically with the first pixel circuit 11 on the base substrate. The second display region A2 may be provided with a plurality of second light emitting elements 14 and a plurality of second pixel circuits 13. At least one second pixel circuit 13 is electrically connected with at least one second light emitting element 14, and is configured to drive the at least one second light emitting element 14 to emit light. An orthographic projection of the second pixel circuit 13 may be at least partially overlapped with an orthographic projection of the second light emitting element 14 connected electrically with the second pixel circuit 13 on the base substrate. For example, a plurality of first pixel circuits 11 may be electrically connected with a plurality of first light emitting elements 12 in one to one correspondence, and a plurality of second pixel circuits 13 may be electrically connected with a plurality of second light emitting elements 14 in one to one correspondence. However, this embodiment is not limited thereto. For example, the first pixel circuits 11 and the first light emitting elements 12 may have a one-to-many relationship. For another example, the second pixel circuits 13 and the second light emitting elements 14 may have a one-to-many relationship.

FIG. 4 is a partial schematic diagram of a first signal line of a display substrate according to at least one embodiment of the present disclosure. In some examples, as shown in FIG. 4, the display substrate includes a plurality of first signal lines L1. A first signal line L1 may provide a first signal in the first direction X to a first pixel circuit in the first display region A1. For example, the first signal line L1 may include at least one of a scan line, a first reset control line, and a light emitting control line.

In some examples, as shown in FIG. 4, the first signal line L1 may include a first sub-signal line L11, a second sub-signal line L12, a third sub-signal line L13, and a fourth sub-signal line L14. The third sub-signal line L13 and the fourth sub-signal line L14 may both extend along the first direction X and are located within the second display region on opposite sides of the first display region A1 along the first direction X. The first sub-signal line L11 may be located within the first display region A1 and extends along the first direction X. Both ends of the first sub-signal line L11 may be electrically connected with the third sub-signal line L13 and the fourth sub-signal line L14, respectively. The second sub-signal line L12 may be located within the second display region. The second sub-signal line L12 may bypass the first display region A1, and both ends of the second sub-signal line L12 may be electrically connected with the third sub-signal line L13 and the fourth sub-signal line L14, respectively. For example, the second sub-signal line L12 may first extend along the second direction Y, then extend along the first direction X, and then extend along the second direction Y. The first sub-signal line L11 and the second sub-signal line L12 of the first signal line L1 are connected in parallel and electrically, and are connected in series with the third sub-signal line L13 and the fourth sub-signal line L14.

In some examples, as shown in FIG. 4, the plurality of first signal lines L1 may be divided into two groups. For example, a first group of first signal lines and a second group of first signal lines may be substantially symmetrical with respect to a first center line O1, along the second direction Y, of the first display region A1. A quantity of first signal lines in the first group of first signal lines and a quantity of first signal lines in the second group of first signal lines may be substantially the same. A second sub-signal line L12 of a first signal line L1 in the first group of first signal lines may be located within the second display region on one side of the first display region A1 along the second direction Y, and a second sub-signal line L12 of a first signal line L1 in the second group of first signal lines may be located within the second display region on the other side of the first display region A1 along the second direction Y. For example, the second sub-signal line L12 of the first group of first signal lines may bypass the first display region A1 from an upper side of the first display region A1, and the second sub-signal line L12 of the second group of first signal lines may bypass the first display region A1 from a lower side of the first display region A1. In this way, trace aggregation may be avoided to affect a display effect adversely.

In some examples, as shown in FIG. 4, a second sub-signal line L12 of a first signal line L1 close to an edge of the first display region A1, in the second direction Y, may be located on a side of a second sub-signal line L12 of a first signal line L1, which is close to the first center line O1, along the second direction Y, of the first display region A1, close to the first display region A1. In other words, a length of the second sub-signal line L12 of the first signal line L1, which is close to the first center line O1, along the second direction Y, of the first display region A1, along the second direction Y may be larger than a length of the second sub-signal line L12 of the first signal line L1 close to the edge of the first display region A1, along the second direction Y. In this way, overlapping of traces may be reduced, which is beneficial to a rational arrangement of second sub-signal lines L12.

In some examples, as shown in FIG. 4, a first signal may be transmitted within the first display region A1 through a first sub-signal line L11, and may also be transmitted within the second display region through a second sub-signal line L12. In this example, a transmission load of a first signal of the first display region A1 may be reduced by disposing a first sub-signal line L11 and a second sub-signal line L12 connected in parallel and electrically to transmit the first signal, thereby improving lateral display mura existing in the second display region on left and right sides of the first display region A1.

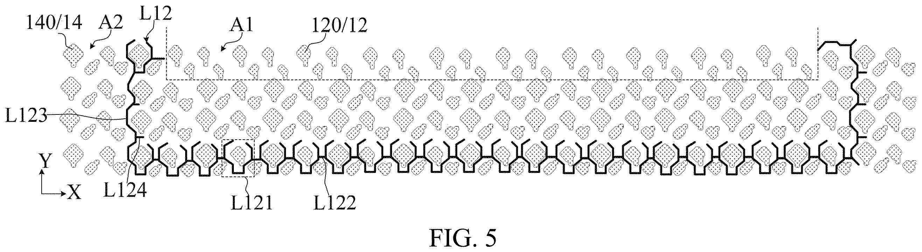

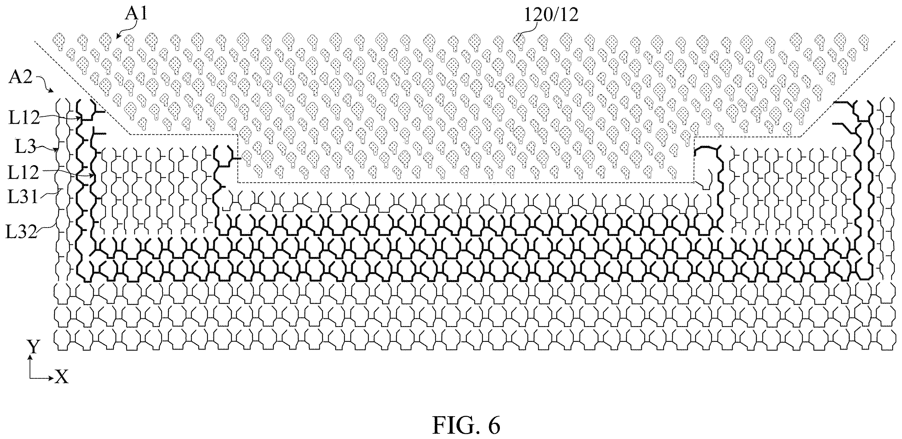

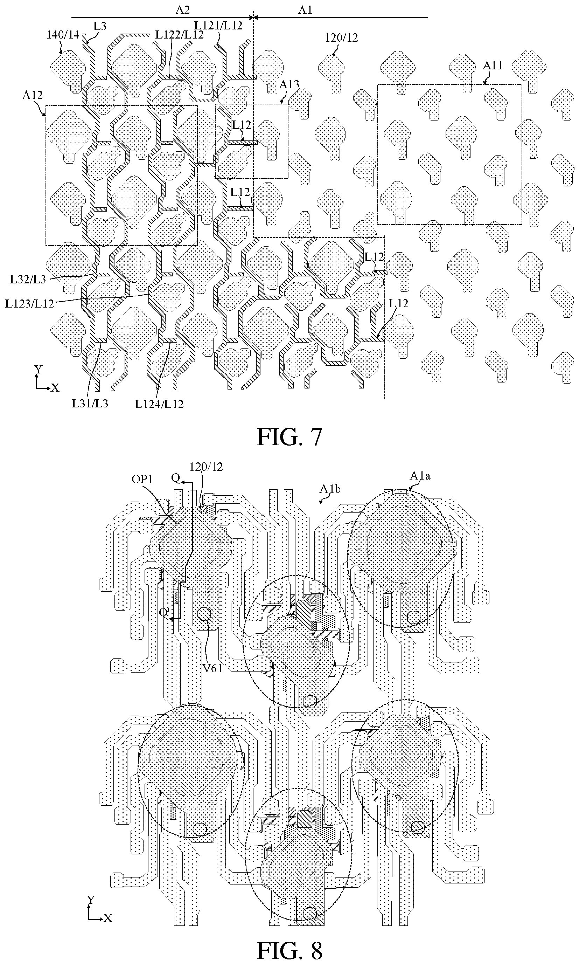

FIG. 5 and FIG. 6 are partial trace schematic diagrams of a display substrate according to at least one embodiment of the present disclosure. FIG. 7 is a partial schematic diagram of a display region according to at least one embodiment of the present disclosure. FIG. 5 shows a second sub-signal line of one first signal line and FIG. 6 shows second sub-signal lines of three first signal lines. FIG. 7 shows anodes 120 of a plurality of first light emitting elements 12 of the first display region A1, anodes 140 of a plurality of second light emitting elements 14 of the second display region A2, and a part of second sub-signal lines L12 and auxiliary traces L3 of the second display region A2.

In some examples, as shown in FIG. 7, a pixel density (Pixel Per Inch (PPI)) of the first display region A1 may be less than a pixel density of the second display region A2. However, this embodiment is not limited thereto. In other examples, the pixel density of the first display region may be equal to the pixel density of the second display region.

In some examples, as shown in FIG. 5 and FIG. 7, an orthographic projection of a second sub-signal line L12 of a first signal line on the base substrate may not be overlapped with an orthographic projection of an anode 140 of a second light emitting element 14 on the base substrate. The second sub-signal line L12 bypasses the anode 140 of the second light emitting element 14 to ensure flatness of the second light emitting element 14, thereby ensuring a light emitting effect of the second light emitting element 14.

In some examples, as shown in FIG. 5 and FIG. 7, the second sub-signal line L12 of the first signal line may include a first connection segment L121, a second connection segment L122, a third connection segment L123, and a fourth connection segment L124. The first connection segment L121 may be in a non-hermetic shape formed by connecting a plurality of straight line segments, and an anode 140 of a second light emitting element 14 may be located within a region surrounded by the first connection segment L121. The first connection segment L121 may partially surround an anode 140 of a second light emitting element 14. The second connection segment L122 may be a straight line segment extending along the first direction X. The second connection segment L122 is connected with an adjacent first connection segment L121. As shown in FIG. 5, the first connection segment L121 and the second connection segment L122 may be connected at intervals, so that the second sub-signal line L12 may bypass the anodes 140 of the plurality of second light emitting elements 14 along the first direction X. The third connection segment L123 may be a fold line extending along the second direction Y, and the fourth connection segment L124 may be a straight line segment extending along the first direction X. A plurality of fourth connection segments L124 may be connected on a side of the third connection segment L123. Only one end of a fourth connection segment L124 is connected with the third connection segment L123. The fourth connection segment L124 may be located between anodes 140 of adjacent second light emitting element 14 arranged along the second direction Y. The second sub-signal line L12 can bypass an anode 140 of a second light emitting element 14 along the second direction Y through the third connection segment L123, and through the fourth connection segment L124, a trace environment around the anode 140 of the second light emitting element 14 may be consistent. However, this embodiment is not limited thereto. In other examples, the first connection segment L121 may be formed by connecting curved line segments, and the second connection segment L122, the third connection segment L123, and the fourth connection segment L124 may be curved line segments.

In some examples, as shown in FIG. 6, portions of the second sub-signal lines L12 of the plurality of first signal lines extending along the first direction X may be arranged adjacent in the second direction Y. Portions of the second sub-signal lines L12 of the plurality of first signal lines extending along the second direction Y may be adjacent or spaced apart from a plurality of auxiliary traces L3. As shown in FIG. 6 and FIG. 7, an auxiliary trace L3 may include a first auxiliary segment L31 and a second auxiliary segment L32. The first auxiliary segment L31 may be a straight line segment extending along the first direction X. The second auxiliary segment L32 may be a fold line extending along the second direction Y. The first auxiliary segment L31 and the second auxiliary segment L32 are connected with each other. A plurality of first auxiliary segments L31 may be connected on a same side of the second auxiliary segment L32. An orthographic projection of the auxiliary trace L3 on the base substrate may be not overlapped with an orthographic projection of an anode 140 of a second light emitting element 14 on the base substrate. A shape of the auxiliary trace L3 may be similar to that of a second sub-signal line L12. In this example, a uniform arrangement of traces in the display region of the display substrate may be ensured by disposing the auxiliary traces L3.

In some examples, as shown in FIG. 7, an anode 140 of at least one second light emitting element 14 within the second display region A2 may be surrounded or partially surrounded by a second sub-signal line L12 and an auxiliary trace L3. Both the second sub-signal line L12 and the auxiliary line L3 are routed by bypassing the anode 140 of the second light emitting element 14, which may ensure flatness of the second light emitting element 14, and may ensure uniformity of a trace environment around the second light emitting element 14, thus avoiding an influence on a light emitting effect of the second light emitting element 14.

Description is given below by taking a case in which a scan line is a first signal line as an example.

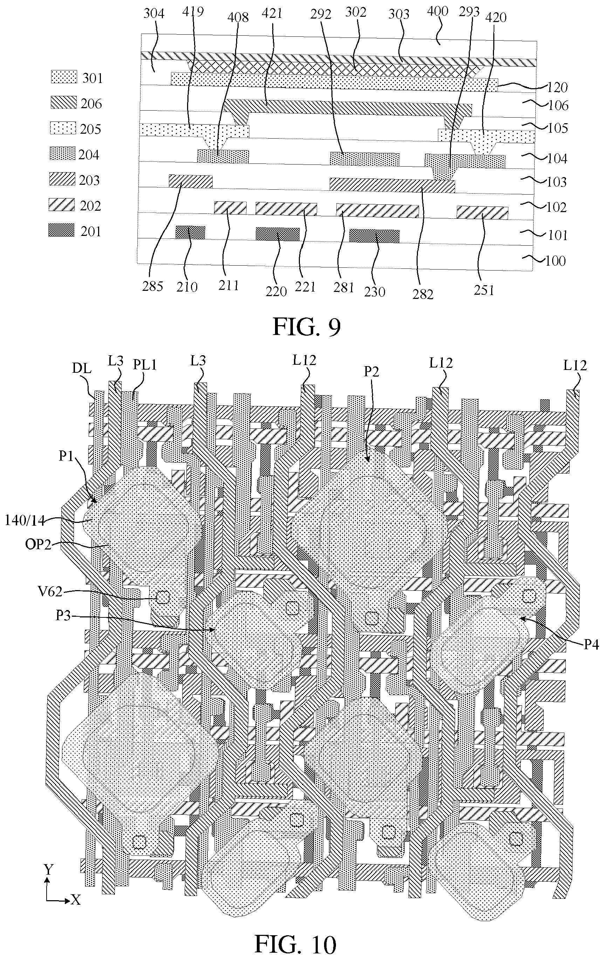

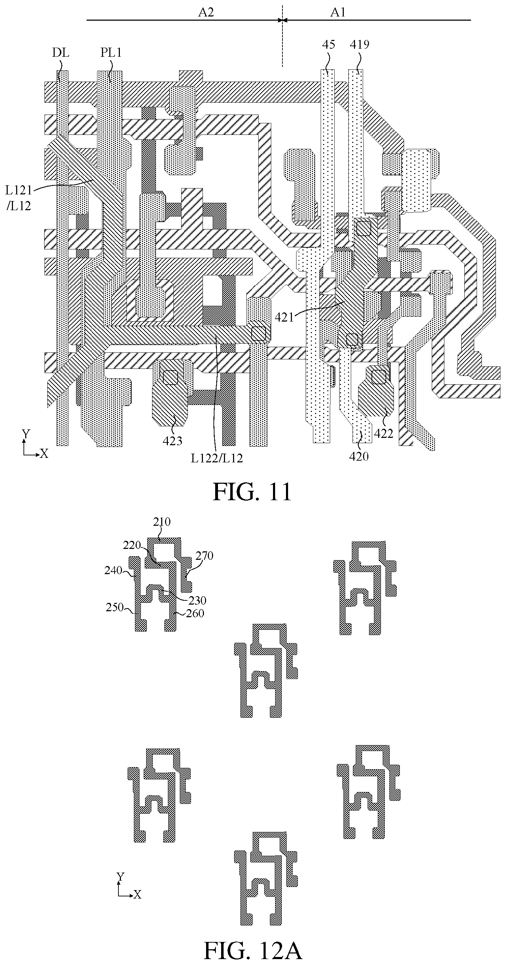

FIG. 8 is a partial plan schematic diagram of a region A11 in FIG. 7. FIG. 9 is a partial cross-sectional schematic diagram along a Q-Q' direction in FIG. 8. FIG. 10 is a partial plan schematic diagram of a region A12 in FIG. 7. FIG. 11 is a partial plan schematic diagram of a region A13 in FIG. 7. FIG. 8 shows six first pixel circuits and six first light emitting elements; FIG. 10 shows eight second pixel circuits and eight second light emitting elements; FIG. 11 shows one first pixel circuit and one second pixel circuit which are adjacent at a junction of the first display region A1 and the second display region A2.

In some examples, as shown in FIG. 8, in a plane parallel to the display substrate, the first display region may include a plurality of display island regions A1a spaced apart from each other, and a light transmitting region A12 located between adjacent display island regions A1a. Each display island region A1a may be configured to perform image display, and each light transmission region A1b may be configured to provide a light transmission space. Shapes of the plurality of display island regions A1a may be approximately the same, and a display island region A1a may have a smooth edge, thereby reducing a light diffraction effect and being beneficial to improvement of a shooting effect. The display island regions A1a within the first display region may be independent of each other, and the light transmission regions A1b within the first display region may be communicated with each other, and the light transmission regions A1b may surround the display island regions A1a. Each display island region A1a may include one sub-pixel. An orthographic projection of a first light emitting element on the base substrate may be overlapped with an orthographic projection of a first pixel circuit connected electrically with the first light emitting element on the base substrate.

In some examples, as shown in FIG. 10, in a plane parallel to the display substrate, one pixel unit within the second display region may include a sub-pixel P1 emitting light of a first color, a sub-pixel P2 emitting light of a second color, a sub-pixel P3 emitting light of a third color, and a sub-pixel P4 emitting light of a fourth color. An orthographic projection of a second light emitting element on the base substrate may be overlapped with an orthographic projection of a second pixel circuit connected electrically with the second light emitting element on the base substrate. A plurality of second pixel circuits of the second display region may be arranged in an array, and a plurality of second light emitting elements may be arranged according to a Pentile structure. For example, second light emitting elements emitting light of the first color and second light emitting elements emitting light of the second color may be alternately arranged along the first direction X and the second direction Y, and second light emitting elements emitting light of the third color and second light emitting elements emitting light of the fourth color may be alternately arranged along the first direction X and the second direction Y; and there are dislocations between rows where second light emitting elements emitting light of the first color and light of the second color are located, and rows where second light emitting elements emitting light of the third color and light of the fourth color are located, and there are dislocations between columns where second light emitting elements emitting light of the first color and light of the second color are located, and columns where second light emitting elements emitting light of the third color and light of the fourth color are located. For example, light of the first color may be red light, light of the second color may be blue light, and light of the third color and light of the fourth color may be green light. An arrangement mode of first pixel circuits and first light emitting elements within the first display region may be referred to an arrangement mode of second light emitting elements, and thus will not be repeated here.

In some examples, as shown in FIG. 9, in a direction perpendicular to the display substrate, the display substrate may include a base substrate 100, and a circuit structure layer, a light emitting structure layer, and an encapsulation structure layer which are disposed on the base substrate 100. The circuit structure layer may include a semiconductor layer 201, a first conductive layer (or referred to as a first gate metal layer) 202, a second conductive layer (or referred to as a second gate metal layer) 203, a third conductive layer (or referred to as a first source-drain metal layer) 204, a transparent conductive layer 205, and a fourth conductive layer (or referred to as a second source-drain metal layer) 206 which are sequentially disposed on the base substrate100. A first insulation layer (or referred to as a first gate insulation layer) 101 is disposed between the semiconductor layer 201 and the first conductive layer 202, a second insulation layer (or referred to as a second gate insulation layer) 102 is disposed between the first conductive layer 202 and the second conductive layer 203, a third insulation layer (or referred to as an interlayer dielectric layer) 103 is disposed between the second conductive layer 203 and the third conductive layer 204, a fourth insulation layer 104 is disposed between the third conductive layer 204 and the transparent conductive layer 205, and a fifth insulation layer 105 is disposed between the transparent conductive layer 205 and the fourth conductive layer 206. A sixth insulation layer 106 is disposed on a side of the fourth conductive layer 206 away from the base substrate100. In some examples, the first insulation layer 101 to the third insulation layer 103 may be inorganic insulation layers, and the fourth insulation layer 104 to the six insulation layer 106 may be organic insulation layers. However, this embodiment is not limited thereto.

In some examples, as shown in FIG. 9, the light emitting structure layer may at least include an anode layer 301, a pixel definition layer 304, an organic emitting layer 302, and a cathode layer 303 that are sequentially disposed on the circuit structure layer. The anode layer 301 may be electrically connected with a pixel circuit (e.g. a first pixel circuit or a second pixel circuit) of the circuit structure layer, the organic emitting layer 302 may be connected with the anode layer 301, the cathode layer 303 may be connected with the organic emitting layer 302, and the organic emitting layer 302 may emit light of a corresponding color under drive of the anode layer 301 and the cathode layer 303. In some examples, the encapsulation layer 400 may include a first encapsulation layer, a second encapsulation layer, and a third encapsulation layer that are stacked, the first encapsulation layer and the third encapsulation layer may be made of an inorganic material, the second encapsulation layer may be made of an organic material, and the second encapsulation layer is disposed between the first encapsulation layer and the third encapsulation layer to form an inorganic material/organic material/inorganic material laminated structure, which may ensure that external water vapor cannot enter the light emitting structure layer. In some possible Implementation modes, the display substrate may further include another film layer, such as a touch structure layer and a color filter layer, and this embodiment is not limited thereto.

A structure of the display substrate will be described below through an example of a preparation process of the display substrate. A "patterning process" mentioned in the embodiments of the present disclosure includes a treatment such as photoresist coating, mask exposure, development, etching, and photoresist stripping for a metal material, an inorganic material, or a transparent conductive material, and includes a treatment such as organic material coating, mask exposure, and development for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a material on a base substrate using deposition, coating, or another process. If the "thin film" does not need a patterning process in an entire manufacturing process, the "thin film" may also be called a "layer". If the "thin film" needs the patterning process in the entire manufacturing process, the "thin film" is called a "thin film" before the patterning process and is called a "layer" after the patterning process. The "layer" after the patterning process contains at least one "pattern".

"A and B are disposed in a same layer" in this specification means that A and B are formed simultaneously through a same patterning process or that distances between surfaces of A and B close to a base substrate and the base substrate are substantially the same, or that the surfaces of A and B close to the base substrate are in direct contact with a same film layer. A "thickness" of a film layer is a dimension of the film layer in a direction perpendicular to the display substrate. In this specification, "an orthographic projection of B being located within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B.

In some exemplary Implementation modes, the preparation process of the display substrate may include following operations.

(1) A base substrate is provided. In some examples, the base substrate may be a rigid base substrate, or may be a flexible base substrate. For example, the rigid base substrate may be made of, but is not limited to, one or more of glass and quartz; and the flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In some examples, the flexible base substrate may include a first flexible material layer, a first inorganic material layer, a second flexible material layer, and a second inorganic material layer which are stacked. Materials of the first flexible material layer and the second flexible material layer may be Polyimide (PI), Polyethylene Terephthalate (PET), or a polymer soft film on which a surface treatment is performed, etc., and materials of the first inorganic material layer and the second inorganic material layer may be Silicon Nitride (SiNx) or Silicon Oxide (SiOx), etc., which are used for improving water and oxygen resistance of the base substrate.

(2) A semiconductor layer is formed. In some examples, a semiconductor thin film is deposited on the base substrate, and the semiconductor thin film is patterned through a patterning process to form a semiconductor layer disposed on the base substrate. In some examples, a material of the semiconductor layer may be amorphous Silicon (a-Si), polycrystalline Silicon (p-Si), hexathiophene or polythiophene, and another material.

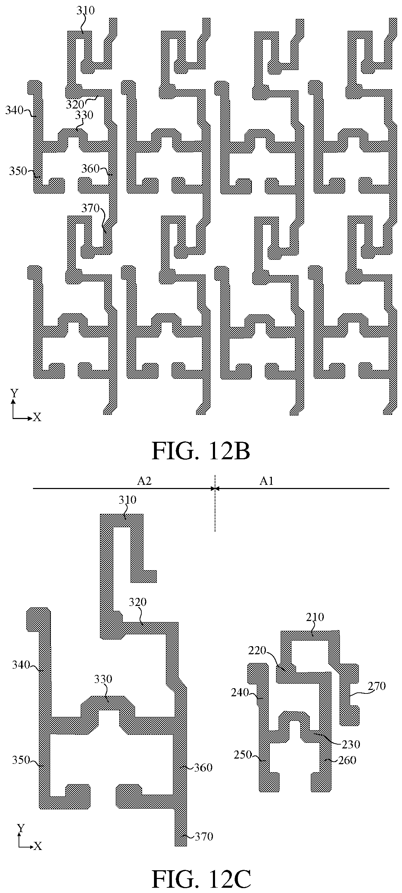

FIG. 12A is a partial schematic diagram of a first display region after a semiconductor layer is formed in FIG. 8. FIG. 12B is a partial schematic diagram of a second display region after a semiconductor layer is formed in FIG. 10. FIG. 12C is a partial schematic diagram of a display region after a semiconductor layer is formed in FIG. 11.

In some examples, as shown in FIG. 12A and FIG. 12C, the semiconductor layer of the first display region may at least include active layers of a plurality of transistors of a first pixel circuit (for example, including a first active layer 210 of a first reset transistor, a second active layer 220 of a threshold compensation transistor, a third active layer 230 of a drive transistor, a fourth active layer 240 of a data writing transistor, a fifth active layer 250 of a first light emitting control transistor, a sixth active layer 260 of a second light emitting control transistor, and a seventh active layer 270 of a second reset transistor of the first pixel circuit). Each active layer may include a channel region, and a first region and a second region which are located on opposite sides of the channel region. Active layers of seven transistors of each first pixel circuit may be of an integral structure. Active layers of transistors of different first pixel circuits are independent of each other. For example, the fourth active layer 240, the fifth active layer 250, the sixth active layer 260, and the seventh active layer 270 of the first pixel circuit may be substantially I-shaped, the first active layer 210 and the third active layer 230 may be substantially n-shaped, and the second active layer 220 may be substantially L-shaped.

In some examples, as shown in FIG. 12B and FIG. 12C, the semiconductor layer of the second display region may at least include active layers of a plurality of transistors of a second pixel circuit (for example, including a first active layer 310 of a first reset transistor, a second active layer 320 of a threshold compensation transistor, a third active layer 330 of a drive transistor, a fourth active layer 340 of a data writing transistor, a fifth active layer 350 of a first light emitting control transistor, a sixth active layer 360 of a second light emitting control transistor, and a seventh active layer 370 of a second reset transistor of the second pixel circuit). Active layers of seven transistors of each second pixel circuit may be of an integral structure, and active layers of transistors of adjacent second pixel circuits along a second direction Y may be of an integral structure. For example, the fourth active layer 340 of the second pixel circuit may be substantially I-shaped, the first active layer 310 and the third active layer 330 may be v n-shaped, and the second active layer 320, the fifth active layer 350, the sixth active layer 360, and the seventh active layer 370 may be substantially L-shaped.

(3) A first conductive layer is formed. In some examples, a first insulation thin film and a first conductive thin film are deposited sequentially on the base substrate, on which the aforementioned structures are formed, and the first conductive thin film is patterned through a patterning process to form a first insulation layer and a first conductive layer disposed on the first insulation layer.

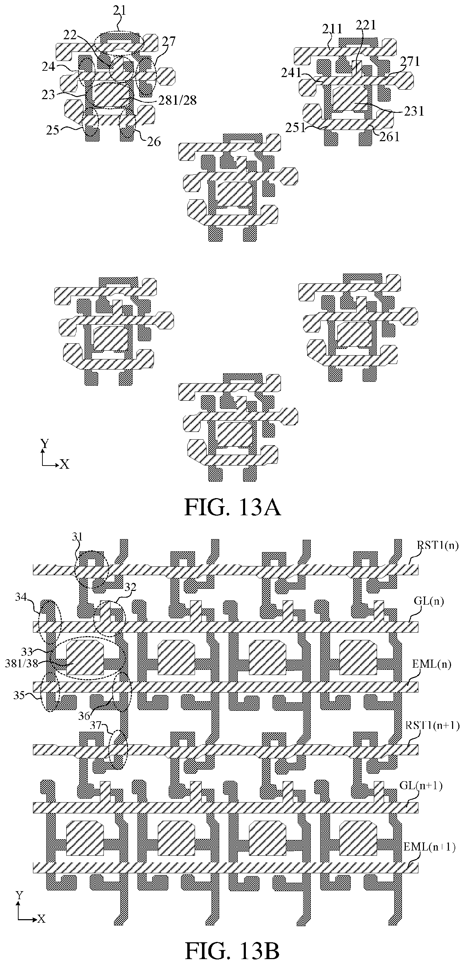

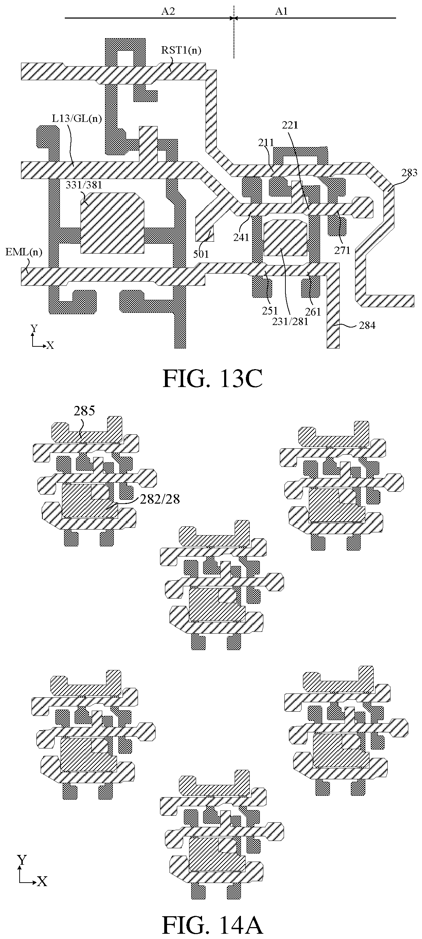

FIG. 13A is a partial schematic diagram of a first display region after a first conductive layer is formed in FIG. 8. FIG. 13B is a partial schematic diagram of a second display region after a first conductive layer is formed in FIG. 10. FIG. 13C is a partial schematic diagram of a display region after a first conductive layer is formed in FIG. 11.

In some examples, as shown in FIG. 13A and FIG. 13C, the first conductive layer of the first display region may at least include gates of a plurality of transistors of a first pixel circuit (including, for example, a gate 211 of a first reset transistor 21, a gate 221 of a threshold compensation transistor 22, a gate 231 of a drive transistor 23, a gate 241 of a data writing transistor 24, a gate 251 of a first light emitting control transistor 25, a gate 261 of a second light emitting control transistor 26, a gate 271 of a second reset transistor 27 of the first pixel circuit), a first electrode plate 281 of a storage capacitor 28 of the first pixel circuit, and a first metal connection line 283 and a second metal connection line 284. Among them, the gate 221 of the threshold compensation transistor 22, the gate 241 of the data writing transistor 24, and the gate 271 of the second reset transistor 27 may be of an integral structure. The gate 231 of the drive transistor and the first electrode plate 281 of the storage capacitor 28 may be of an integral structure. The gate 251 of the first light emitting control transistor 25, and the gate 26 of the second light emitting control transistor 261 may be of an integral structure. The gate 211 of the first reset transistor 21 of the first pixel circuit and the first metal connection line 283 may be of an integral structure. The gate 211 of the first reset transistor 21 of adjacent first pixel circuits close to a junction of the first display region and the second display region may be electrically connected through the first metal connection line 283. The gate 261 of the second light emitting control transistor 26 of the first pixel circuit and the second metal connection line 284 may be of an integral structure. The gate 251 of the first light emitting control transistor 25 and the gate 261 of the second light emitting control transistor 26 of adjacent first pixel circuits close to the junction of the first display region and the second display region may be electrically connected through the second metal connection line 284.

In some examples, as shown in FIG. 13B and FIG. 13C, the first conductive layer of the second display region may at least include gates of a plurality of transistors of a second pixel circuit (for example, including a gate of a first reset transistor 31, a gate of a threshold compensation transistor 32, a gate of a drive transistor 33, a gate of a data writing transistor 34, a gate of a first light emitting control transistor 35, a gate of a second light emitting control transistor 36, and a gate of a second reset transistor 37 of the second pixel circuit), a first electrode plate 381 of a storage capacitor 38 of the second pixel circuit, a plurality of scan lines (e.g., GL(n) and GL(n+1)), a plurality of first reset control lines (e.g., RST1(n) and RST1(n+1)), a plurality of light emitting control lines (e.g., EML(n) and EML(n+1)). Among them, a gate of a first reset transistor 31 of a second pixel circuit of a present row, a gate of a second reset transistor 37 of a second pixel circuit of a previous row, and a first reset control line RST1(n) may be of an integral structure. A gate of a threshold compensation transistor 32, a gate of a data writing transistor 34 of the second pixel circuit of the present row, and a scan line GL(n) may be of an integral structure. The gate of the drive transistor 33 and the first electrode plate 381 of the storage capacitor 38 of the second pixel circuit may of an integral structure. A gate of a first light emitting control transistor 35, a gate of a second light emitting control transistor 36 of the pixel circuit of the present row, and a light emitting control line EML(n) may be of an integral structure.

In some examples, as shown in FIG. 13C, the first reset control line RST1(n) is electrically connected with the gate 211 of the first reset transistor 21 of the first pixel circuit at a junction of the first display region and the second display region, and may be of an integral structure, for example. The light emitting control line EML(n) is electrically connected with the gate 251 of the first light emitting control transistor 25 of the first pixel circuit, and may be of an integral structure, for example. The third sub-signal line L13 of the scan line GL(n) is electrically connected with the gate 241 of the data writing transistor 24 of the first pixel circuit, and may be of an integral structure, for example. The third sub-signal line L13 of the scan line GL(n) may also have a first transfer end 501 so as to be electrically connected with the second sub-signal line L12 through the first transfer end 501. The first transfer end 501 may be located between the first electrode plate 281 of the storage capacitor 28 of the first pixel circuit and the first electrode plate 381 of the storage capacitor 38 of the second pixel circuit.

In some examples, after the first conductive layer is formed, the first conductive layer may be used as a shield to perform a conductive processing on the semiconductor layer. The semiconductor layer in a region, which is shielded by the first conductive layer, forms channel regions of a plurality of transistors, and the semiconductor layer in a region, which is not shielded by the first conductive layer, is made to be conductive, that is, both a first region and a second region of an active layer of a transistor are made to be conductive.

(4) A second conductive layer is formed. In some examples, a second insulation thin film and a second conductive thin film are deposited sequentially on the base substrate, on which the aforementioned structures are formed, and the second conductive thin film is patterned through a patterning process to form a second insulation layer and a second conductive layer disposed on the second insulation layer.

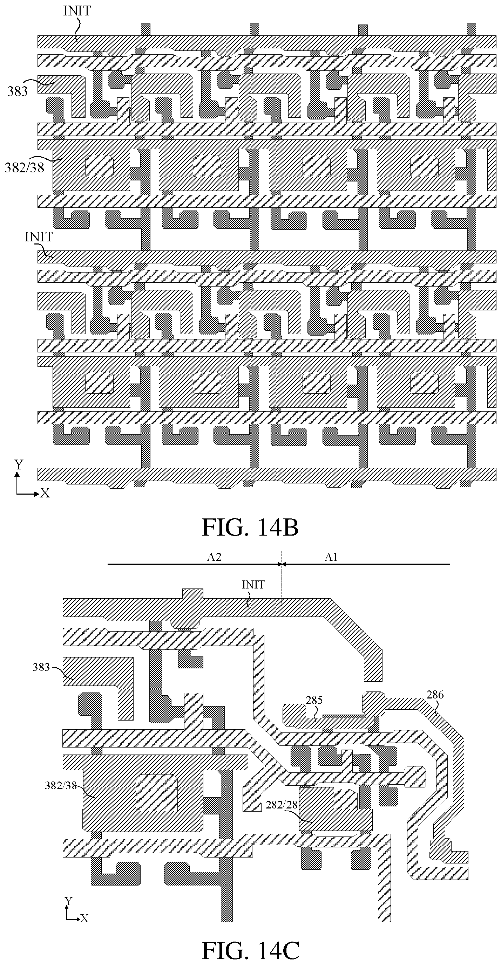

FIG. 14A is a partial schematic diagram of a first display region after a second conductive layer is formed in FIG. 8. FIG. 14B is a partial schematic diagram of a second display region after a second conductive layer is formed in FIG. 10. FIG. 14C is a partial schematic diagram of a display region after a second conductive layer is formed in FIG. 11.

In some examples, as shown in FIG. 14A and FIG. 14C, the second conductive layer of the first display region may at least include a second electrode plate 282 of the storage capacitor 28 of the first pixel circuit, a third metal connection line 285, and a fourth metal connection line 286. An orthographic projection of the second electrode plate 282 of the storage capacitor 28 on the base substrate is overlapped with an orthographic projection of the first electrode plate 281 on the base substrate. The third metal connection line 285 is configured to transmit an initial signal within a display island region (a display island region A1a as shown in FIG. 8). The fourth metal connection line 286 is configured to transmit an initial signal between display island regions. The third metal connection line 285 within adjacent display island regions close to a junction of the first display region and the second display region may be electrically connected through the fourth metal connection line 286. The third metal connection line 285 and the fourth metal connection line 286 may be of an integral structure.

In some examples, as shown in FIG. 14B and FIG. 14C, the second conductive layer of the second display region may include at least a second electrode plate 382 of the storage capacitor 38 of the second pixel circuit, a shielding electrode 383, and an initial signal line INIT. An orthographic projection of the second electrode plate 382 of the storage capacitor 38 of the second pixel circuit on the base substrate may be overlapped with an orthographic projection of the first electrode plate 381 on the base substrate. An orthographic projection of the shielding electrode 383 on the base substrate may be overlapped with an orthographic projection of an active layer of the threshold compensation transistor 32 of the second pixel circuit on the base substrate. The shielding electrode 383 is configured to protect the threshold compensation transistor and shield an interference of another signal to the threshold compensation transistor. The initial signal line INIT may extend along a first direction X and extend to the first display region to be adjacent to the fourth metal connection line 286 in the second direction Y.

(5) A third insulation layer is formed. In some examples, a third insulation thin film is deposited on the base substrate on which the aforementioned patterns are formed, and the third insulation thin film is patterned through a patterning process to form a third insulation layer.

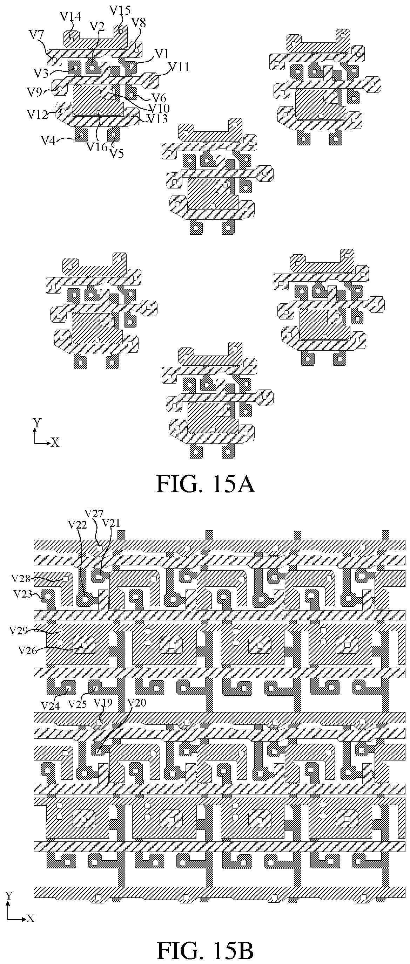

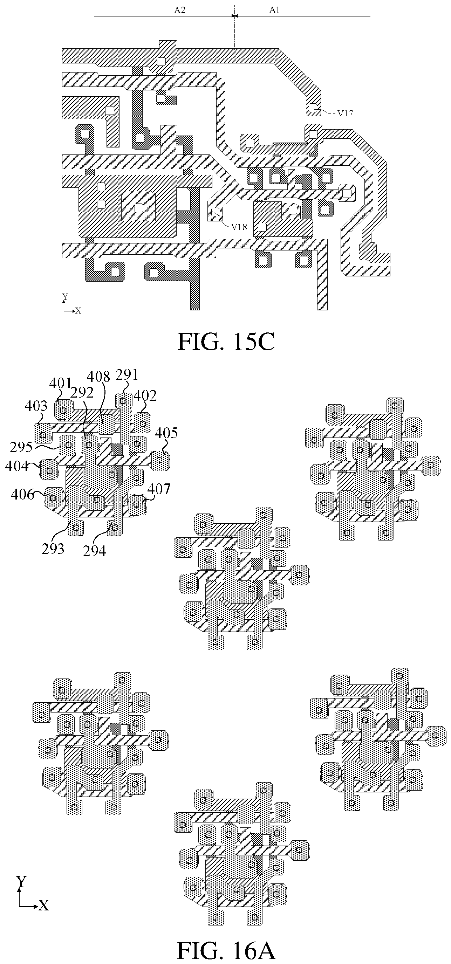

FIG. 15A is a partial schematic diagram of a first display region after a third insulation layer is formed in FIG. 8. FIG. 15B is a partial schematic diagram of a second display substrate after a third insulation layer is formed in FIG. 10. FIG. 15C is a partial schematic diagram of a display region after a third insulation layer is formed in FIG. 11.

In some examples, as shown in FIG. 15A to FIG. 15C, the third insulation layer of the display region may be provided with a plurality of vias, which may include, for example, a first type of via exposing a surface of the semiconductor layer, a second type of via exposing a surface of the first conductive layer, and a third type of via exposing a surface of the second conductive layer.

In some examples, as shown in FIG. 15A and FIG. 15C, a first type of via of the first display region may include a first via V1 to a sixth via V6, a second type of via may include a seventh via V7 to a thirteenth via V13, and a third type of via may include a fourteenth via V14 to a seventeenth via V17.

In some examples, as shown in FIG. 15B and FIG. 15C, a first type of via of the second display region may include a twentieth via V20 to a twenty-fifth via V25, a second type of via may include a twenty-sixth via V26 and an eighteenth via V18, and a third type of via may include a twenty-seventh via V27 to a twenty-ninth via V29.

(6) A third conductive layer is formed. In some examples, a third conductive thin film is deposited on the base substrate, on which the aforementioned patterns are formed, and the third conductive thin film is patterned through a patterning process to form the third conductive layer on the third insulation layer.

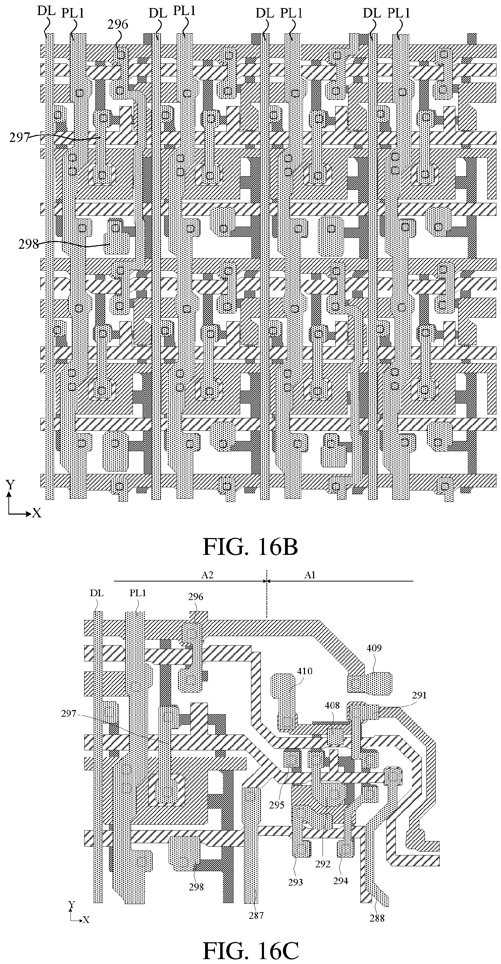

FIG. 16A is a partial schematic diagram of a first display region after a third conductive layer is formed in FIG. 8. FIG. 16B is a partial schematic diagram of a second display region after a third conductive layer is formed in FIG. 10.

FIG. 16C is a partial schematic diagram of a display region after a third conductive layer is formed in FIG. 11.

In some examples, as shown in FIG. 16A and FIG. 16C, the third conductive layer of the first display region may at least include a plurality of pixel electrodes (including, for example, a first pixel electrode 291 to a fifth pixel electrode 295), a plurality transfer electrodes (including, for example, a first transfer electrode 401 to a tenth transfer electrode 410), and a sixth metal connection line 288.

In some examples, as shown in FIG. 12A to FIG. 16C, the first pixel electrode 291 may be electrically connected with a first region of the first active layer 210 of the first reset transistor of the first pixel circuit through the first via V1, and may also be electrically connected with the third metal connection line 285 through the fifteenth via V15. The second pixel electrode 292 may be electrically connected with a first region of the second active layer 220 of the threshold compensation transistor through the second via V2, and may also be electrically connected with the gate 231 of the drive transistor through the tenth via V10. The third pixel electrode 293 may be electrically connected with a first region of the fifth active layer 250 of the first light emitting control transistor through the fourth via V4, and may also be electrically connected with the second electrode plate 282 of the storage capacitor 28 through the sixteenth via V16. The fourth pixel electrode 294 may be electrically connected with a second region of the sixth active layer 260 of the second light emitting control transistor through the fifth via V5, and may also be electrically connected with a second region of the seventh active layer 270 of the second reset transistor through the sixth via V6. The fifth pixel electrode 295 may be electrically connected with a first region of the fourth active layer 240 of the data writing transistor through the third via V3.

In some examples, as shown in FIG. 12A to FIG. 16C, the first transfer electrode 401 may be electrically connected with the third metal connection line 285 through the fourteenth via V14. The second transfer electrode 402 may be electrically connected with one end of the gate 211 of the first reset transistor through the eighth via V8. The third transfer electrode 403 may be electrically connected with the other end of the gate 211 of the first reset transistor through the seventh via V7. The fourth transfer electrode 404 may be electrically connected with the gate 241 of the data writing transistor through the ninth via V9. The fifth transfer electrode 405 may be electrically connected with the gate 271 of the second reset transistor through the eleventh via V11. The sixth transfer electrode 406 may be electrically connected with the gate 251 of the first light emitting control transistor through the twelfth via V12. The seventh transfer electrode 407 may be electrically connected with the gate 261 of the second light emitting control transistor through the thirteenth via V13. The ninth transfer electrode 409 may be electrically connected with the initial signal line INIT1 through the seventeenth via V17. The tenth transfer electrode 410 may be electrically connected with one end of the third metal connection line 285 close to a boundary of the first display region and the second display region through the fourteenth via V14.

In some examples, as shown in FIG. 12A to FIG. 16C, the sixth metal connection line 288 is configured to transmit a scan signal between display island regions. One end of the sixth metal connection line 288 is electrically connected with the gate 271 of the second reset transistor 27 of the first pixel circuit. A gate of a second reset transistor and a gate of a data writing transistor within adjacent display island region close to the junction of the first display region and the second display region may be electrically connected through the sixth metal connection line 288.

In some examples, as shown in FIG. 16B and FIG. 16C, the third conductive layer of the second display region may at least include a data line DL, a first power supply line PL1, a plurality of pixel electrodes (including, for example, a sixth pixel electrode 296, a seventh pixel electrode 297, and an eighth pixel electrode 298), and a fifth metal connection line 287. The data line DL and the first power supply line PL1 may both extend along the second direction Y. The data line DL and the first power supply line PL1, which are electrically connected with second pixel circuits of a same column, are adjacent in the first direction X.

In some examples, as shown in FIG. 12A to FIG. 16C, the sixth pixel electrode 296 may be electrically connected with a first region of the active layer 310 of the first reset transistor of the second pixel circuit through the twenty-first via V21, and may also be electrically connected with one initial signal line INIT through the twenty-seventh via V27. The sixth pixel electrode 296 may also be electrically connected with a first region of the seventh active layer 370 of the second reset transistor through the twentieth via V20, and may also be electrically connected with another initial signal line INIT through the nineteenth via V19. The sixth pixel electrode 296 of this example may extend along the second direction Y, thereby achieving transmission of an initial signal along the second direction Y. The sixth pixel electrode 296 and the initial signal line INIT of this example may be connected to form a mesh structure for transmitting the initial signal, thereby ensuring uniformity of the initial signal.

In some examples, as shown in FIG. 12A to FIG. 16C, the seventh pixel electrode 297 may be electrically connected with a first region of the second active layer 320 of the threshold compensation transistor of the second pixel circuit through the twenty-second via V22, and may also be electrically connected with the gate of the drive transistor 33 through the twenty-sixth via V26. The eighth pixel electrode 298 may be electrically connected with a second region of the sixth active layer 360 of the second light emitting control transistor 36 through the twenty-fifth via V25.

In some examples, as shown in FIG. 12A to FIG. 16C, the data line DL may be connected with a first region of the fourth active layer 340 of the data writing transistor 34 through the twenty-third via V23. The first power supply line PL1 may be electrically connected with the shielding electrode 383 through the twenty-eighth via V28, and may also be electrically connected with the second electrode plate 382 of the storage capacitor 38 through two twenty-ninth vias V29 arranged vertically, and may also be electrically connected with a first region of the fifth active layer 350 of the first light emitting control transistor 35 through the twenty-fourth via V24.

In some examples, as shown in FIG. 16C, the fifth metal connection line 287 may be electrically connected with the first transfer end 501 of the third sub-signal line L13 of the scan line GL(n) through the eighteenth via V18. The fifth metal connection line 287 may extend along the second direction Y and is electrically connected with a first reset control line RST1(n+1) electrically connected with a pixel circuit of a next row.

(7) A fourth insulation layer is formed. In some examples, a fourth insulation thin film is coated on the base substrate on which the aforementioned patterns are formed, and the fourth insulation thin film is patterned through a patterning process to form a fourth insulation layer.

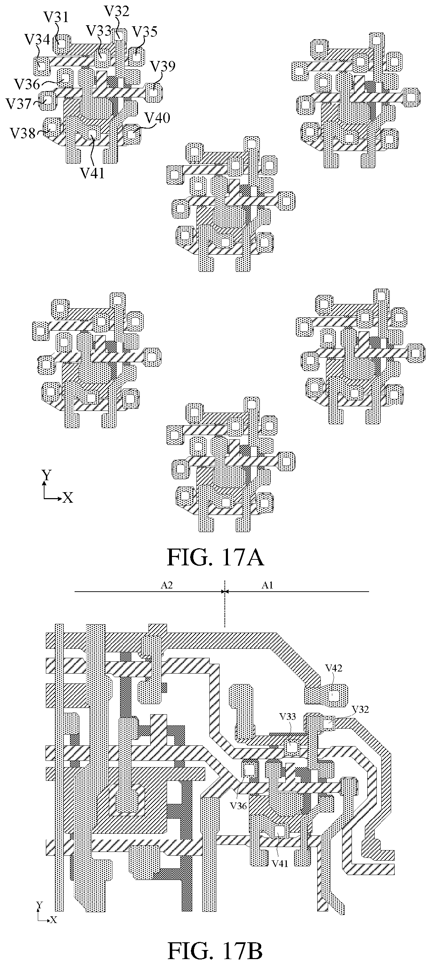

FIG. 17A is a partial schematic diagram of a first display region after a fourth insulation layer is formed in FIG. 8. FIG. 17B is a partial schematic diagram of a display region after a fourth insulation layer is formed in FIG. 11.

In some examples, as shown in FIG. 17A and FIG. 17B, the fourth insulation layer of the display region may be provided with a plurality of vias in the first display region, which may include, for example, a fourth type of via exposing a surface of the third conductive layer. The fourth type of via of the first display region may include a thirty-first via V31 to a forty-second via V42.

(8) A transparent conductive layer is formed. In some examples, a transparent conductive thin film is deposited on the base substrate, on which the aforementioned patterns are formed, and the transparent conductive thin film is patterned through a patterning process to form a transparent conductive layer in the first display region.

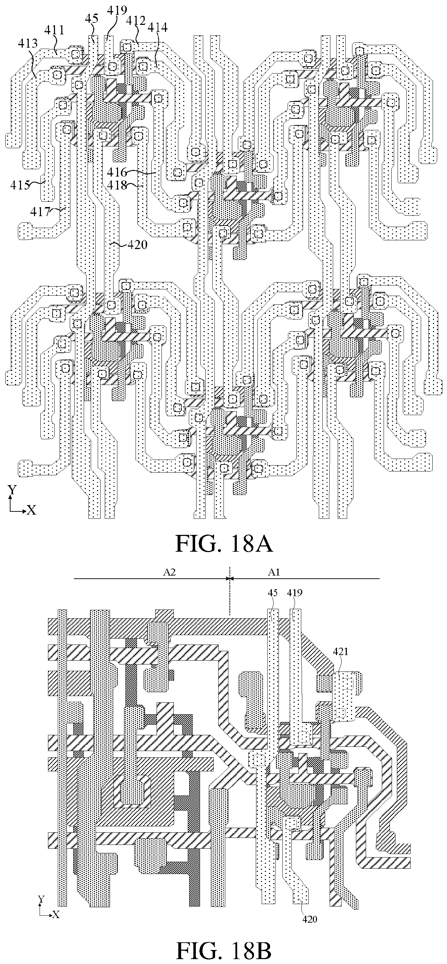

FIG. 18A is a partial schematic diagram of a first display region after a transparent conductive layer is formed in FIG. 8. FIG. 18B is a partial schematic diagram of a display region after a transparent conductive layer is formed in FIG. 11.

In some examples, as shown in FIG. 18A and FIG. 18B, the transparent conductive layer of the first display region may at least include a data connection line 45, a first power supply transfer line 419, a second power supply transfer line 420, a plurality of transfer lines (e.g., a first transfer line 411 to an eighth transfer line 418), and a first connection electrode 421.

In some examples, as shown in FIG. 16A to FIG. 18B, the data connection line 45 may extend along the second direction Y. The data connection line 45 may be electrically connected with a fifth pixel electrode 295 through the thirty-sixth via V36, thereby achieving an electrical connection between the data connection line 45 and a first electrode of a data writing transistor 24 of a first pixel circuit. The first power supply transfer line 419 may extend along the second direction Y, one end of the first power supply transfer line 419 may be electrically connected with an eighth transfer electrode 408 through the thirty-third via V33, and the other end may be electrically connected with a third pixel electrode 293 of another first pixel circuit. The second power supply transfer line 420 may extend along the second direction Y, one end of the second power supply transfer line 420 may be electrically connected with a third pixel electrode 293 through the forty-first via V41, and the other end may be electrically connected with an eighth transfer electrode 408 of another first pixel circuit. In the first display region, a first voltage signal may be transmitted along the second direction Y using the first power supply transfer line 419 and the second supply power transfer line 420.

In some examples, as shown in FIG. 16A to FIG. 18B, one end of the first transfer line 411 may be electrically connected with a first transfer electrode 401 within one display island region through the thirty-first via V31, and the other end may extend to another display island region. One end of the second transfer line 412 may be electrically connected with a first pixel electrode 291 through the thirty-second via V32, and the other end may extend to another display island region. In this example, transmission of an initial signal may be achieved in the first display region using the first transfer line 411, the first transfer electrode 401, the third metal connection line 285, the first pixel electrode 291, and the second transfer line 412.

One end of the third transfer line 413 may be electrically connected with a third transfer electrode 403 within one display island region through the thirty-fourth via V34, and the other end may extend to another display island region. One end of the fourth transfer line 414 may be electrically connected with the second transfer electrode 402 through the thirty-fifth via V35, and the other end may extend to another display island region. In the first display region, transmission of a first reset control signal may be achieved using the third transfer line 413, the third transfer electrode 403, the gate 211 of the first reset transistor, the second transfer electrode 402, and the fourth transfer line 414.

One end of the fifth transfer line 415 may be electrically connected with a fourth transfer electrode 404 within one display island region through the thirty-seventh via V37, and the other end may extend to another display island region. One end of the sixth transfer line 416 may be electrically connected with a fifth transfer electrode 405 through the thirty-ninth via V39, and the other end may extend to another display island region. In the first display region, transmission of a scan signal may be achieved using the fifth transfer line 415, the fourth transfer electrode 404, the gate 241 of the data writing transistor, the gate 221 of the threshold compensation transistor, the gate 271 of the second reset transistor, the fifth transfer electrode 405, and the sixth transfer line 416.

One end of the seventh transfer line 417 may be electrically connected with a sixth transfer electrode 406 within one display island region through the thirty-eighth via V38, and the other end may extend to another display island region. One end of the eighth transfer line 418 may be electrically connected with a seventh transfer electrode 407 through the fortieth via V40, and the other end may extend to another display island region. In the first display region, transmission of a light emitting control signal may be achieved using the seventh transfer line 417, the sixth transfer electrode 406, the gate 251 of the first light emitting control transistor, the gate 261 of the second light emitting control transistor, the seventh transfer electrode 407, and the eighth transfer line 418.

In some examples, as shown in FIG. 18B, the first connection electrode 421 may be electrically connected with a ninth transfer electrode 409 through the forty-second Via V42, and may also be electrically connected with a first pixel electrode 291 of a first pixel circuit through one thirty-second via V32. An initial signal is transmitted close to a junction of the first display region and the second display region using the initial signal line INIT, the ninth transfer electrode 409, the first connection electrode 421, and the first pixel electrode 291.

(9) A fifth insulation layer is formed. In some examples, a fifth insulation thin film is coated on the base substrate on which the aforementioned patterns are formed, and the fifth insulation thin film is patterned through a patterning process to form a fifth insulation layer.

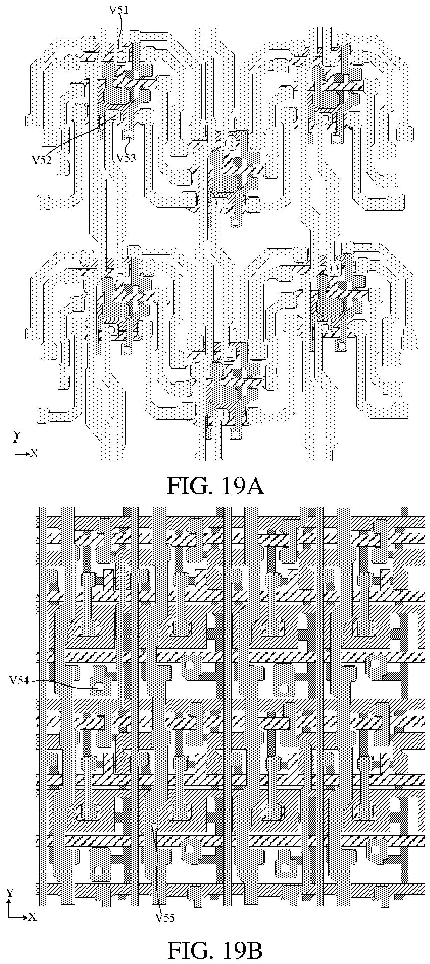

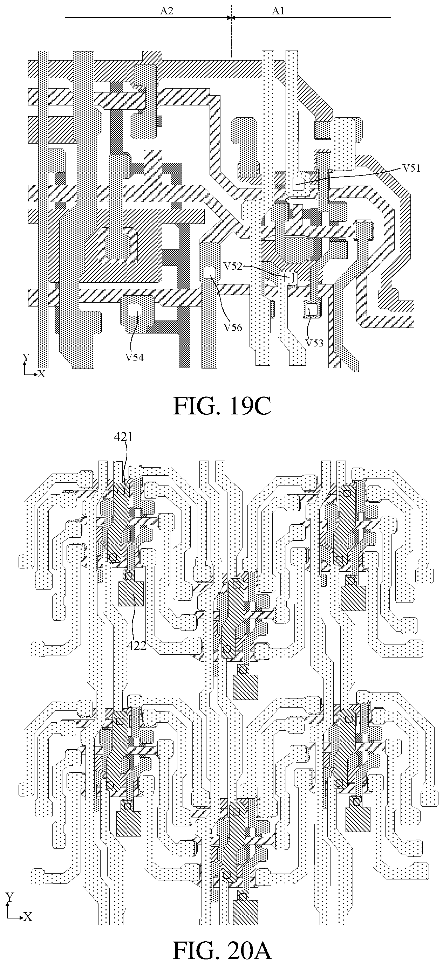

FIG. 19A is a partial schematic diagram of a first display region after a fifth insulation layer is formed in FIG. 8. FIG. 19B is a partial schematic diagram of a second display substrate after a fifth insulation layer is formed in FIG. 10. FIG. 19C is a partial schematic diagram of a display region after a fifth insulation layer is formed in FIG. 11.

In some examples, as shown in FIG. 19A to FIG. 19C, the fifth insulation layer of the display region may be provided with a plurality of vias, which may include, for example, a fifth type of via exposing the surface of the third conductive layer, and a sixth type of via exposing a surface of the transparent conductive layer.

In some examples, as shown in FIG. 19A and FIG. 19C, a sixth type of via of the first display region may include a fifty-first via V51 and a fifty-second via V52, and a fifth type of via may include a fifty-third via V53.

In some examples, as shown in FIG. 19B and FIG. 19C, a fifth type of via of the second display region may include a fifty-fourth via V54 to a fifty-sixth via V56.

(10) A fourth conductive layer is formed. In some examples, a fourth conductive thin film is deposited on the base substrate on which the aforementioned patterns are formed, and the fourth conductive thin film is patterned through a patterning process to form the fourth conductive layer in the first display region.

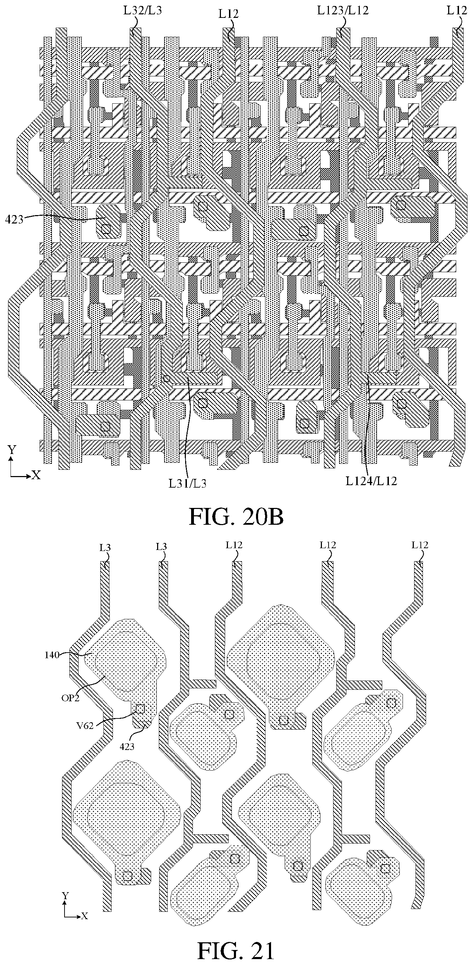

FIG. 20A is a partial schematic diagram of a first display region after a fourth conductive layer is formed in FIG. 8. FIG. 20B is a partial schematic diagram of a second display region after a fourth conductive layer is formed in FIG. 10. FIG. 11 is a partial schematic diagram of a display region after a fourth conductive layer is formed.

In some examples, as shown in FIG. 20A and FIG. 11, the fourth conductive layer of the first display region may at least include a power supply connection electrode 421 and a first anode connection electrode 422. One end of the power supply connection electrode 421 may be electrically connected with a first power supply transfer line 419 through the fifty-first via V51, and the other end may be electrically connected with a second power supply transfer line 420 through the fifty-second via V52. Within the first display region, transmission of a first voltage signal along the second direction Y is achieved using the first power supply transfer line 419, the power supply connection electrode 421, and the second power supply transfer line 420. The first anode connection electrode 422 may be electrically connected with the fourth pixel electrode 294 through the fifty-third via V53, thereby achieving an electrical connection with a second electrode of the sixth active layer 260 of the second light emitting control transistor.

In some examples, as shown in FIG. 20B and FIG. 11, the fourth conductive layer of the second display region may at least include a second anode connection electrode 423, a second sub-signal line L12, and an auxiliary trace L3. The second anode connection electrode 423 may be electrically connected with the eighth pixel electrode 298 through the fifty-fourth via V54. The auxiliary trace L3 may include a first auxiliary segment L31 extending along the first direction X and a second auxiliary segment L32 extending along the second direction Y. The second auxiliary segment L32 may be electrically connected with a first power supply line PL1 through the fifty-fifth via V55. One end of the first auxiliary segment L31 is connected with the second auxiliary segment L32, and the other end is independently disposed. In this example, the auxiliary trace L3 is electrically connected with the first power supply line PL1, and a first voltage signal may be transmitted, which is beneficial to improving display uniformity of the display substrate.

As shown in FIG. 20B and FIG. 11, the second sub-signal line L12 may include a first connection segment L121, a second connection segment L121 extending along the first direction X, a third connection segment L123 extending along the second direction Y, and a fourth connection segment L124 extending along the first direction X. One end of the fourth connection segment L124 is connected with the third connection segment L123, and the other end is independently disposed. One end of one second connection segment L122 is connected with the first connection segment L121, and the other end may be electrically connected with a fifth metal connection line 287 through the fifty-sixth via V56. In this example, the second sub-signal line L12 may be electrically connected with a third sub-signal line L13 through the fifth metal connection line 287. However, this embodiment is not limited thereto. In other examples, the second sub-signal line L12 may be electrically connected directly with a first connection end 501 of the third sub-signal line L13.

In some examples, an orthographic projection of the second sub-signal line L12 and the auxiliary trace L3 on the base substrate may be not overlapped with an orthographic projection of a first node of a second pixel circuit (i.e., a connection point of a gate of a drive transistor, a first electrode of a threshold compensation transistor, and a first electrode plate of a storage capacitor) on the base substrate. A second sub-signal line and an auxiliary trace are disposed to avoid a first node of a second pixel circuit, which may reduce crosstalk of a first signal (e.g., a scan signal) to a first node N1.

A third sub-signal line L13 of a scan line GL(n) in this example may be electrically connected with the second sub-signal line L12 at a junction of the first display region and the second display region, and is electrically connected with a gate of a data writing transistor, a gate of a threshold compensation transistor, and a gate of a second reset transistor of a first pixel circuit within the first display region. Within the first display region, a gate of a data writing transistor and a gate of a second reset transistor of a first pixel circuit within adjacent display island regions may be electrically connected through the sixth transfer line 416, and a gate of a data writing transistor and a gate of a second reset transistor of a first pixel circuit within adjacent display island regions adjacent to a boundary of the first display region may be electrically connected through the sixth metal connection line 288 located in the third conductive layer. In this example, a first sub-signal line of a scan line may include a plurality of sixth transfer lines 416, achieving transmission of a scan signal within the first display region. A third sub-signal line of the scan line may be electrically connected with the first sub-signal line through a sixth metal connection line 288, the gate of the data writing transistor, the gate of the threshold compensation transistor, and the gate of the second reset transistor of the first pixel circuit, and the third sub-signal line may be electrically connected with a second sub-signal line through a fifth metal connection line 287.

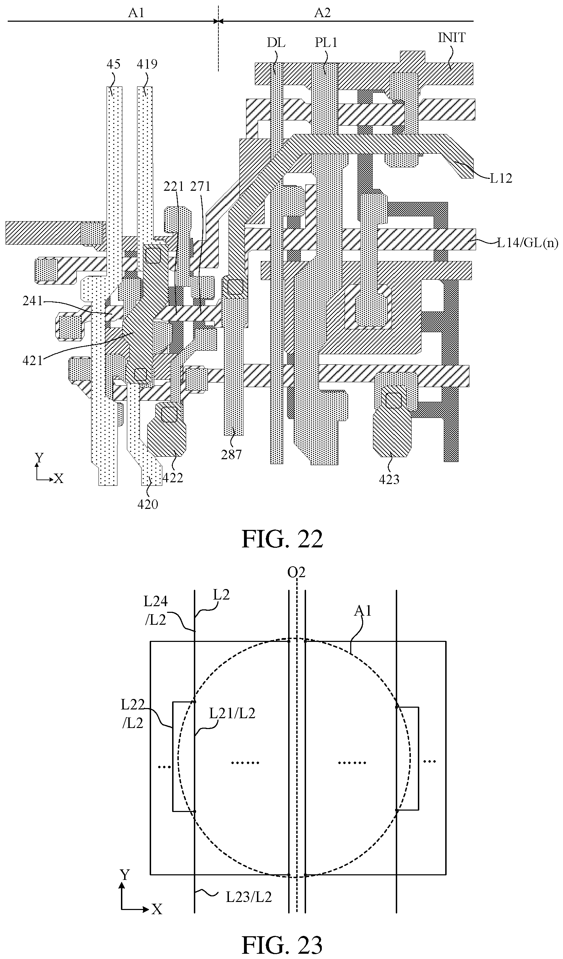

FIG. 22 is a schematic diagram of a trace at a junction of a first display region and a second display region according to at least one embodiment of the present disclosure. In some examples, as shown in FIG. 22, a fourth sub-signal line L14 of the scan line GL(n) may be electrically connected with a second sub-signal line L12 at a junction of the first display region A1 and the second display region A2, and is electrically connected with the gate 241 of the data writing transistor, the gate 221 of the threshold compensation transistor, and the gate 271 of the second reset transistor of the first pixel circuit within the first display region A1. For example, the fourth sub-signal line L14, and the gate 241 of the data writing transistor, the gate 221 of the threshold compensation transistor, and the gate 271 of the second reset transistor of the first pixel circuit, which is close to the junction of the first display region A1 and the second display region A2, within the first display region A1 may be of an integral structure. The fourth sub-signal line L14 of the scan line GL(n) may be electrically connected with the first sub-signal line through the gate 241 of the data writing transistor, the gate 221 of the threshold compensation transistor, and the gate 271 of the second reset transistor of the first pixel circuit, and the fourth sub-signal line L14 may also be electrically connected with the second sub-signal line L12 through the fifth metal connection line 287. Other structures at the junction of the first display region and the second display region may be referred to description of the aforementioned embodiments, and thus will not be repeated here. A connection manner of the fourth sub-signal line and the third sub-signal line with the first sub-signal line and the second sub-signal line in this example is beneficial to an arrangement of pixel circuits, which may save space and facilitate an arrangement of traces.

(11) A sixth insulation layer, a light emitting structure layer, and an encapsulation structure layer are formed sequentially.

In some examples, a sixth insulation thin film is coated on the base substrate on which the aforementioned patterns are formed, and the sixth insulation thin film is patterned through a patterning process to form a sixth insulation layer. In some examples, as shown in FIG. 8, the sixth insulation layer of the first display region may be provided with a plurality of vias, e.g., a sixty-first via V61. As shown in FIG. 10, the sixth insulation layer of the second display region may be provided with a plurality of vias, e.g., a sixty-second via V62.

In some examples, an anode thin film is deposited on the base substrate on which the aforementioned patterns are formed, and the anode thin film is patterned through a patterning process to form an anode layer.

In some examples, as shown in FIG. 8 and FIG. 10, the anode layer of the first display region may include an anode 120 of a first light emitting element 12, and the anode layer of the second display region may include an anode 140 of a second light emitting element 14. The anode 120 of the first light emitting element 12 may be electrically connected with a first anode connection electrode 422 through the sixty-first via V61. The anode 140 of the second light emitting element 14 may be electrically connected with a second anode connection electrode 423 through the sixty-second via V62.

FIG. 21 is a schematic diagram of an anode layer and a fourth conductive layer in FIG. 10. In some examples, as shown in FIG. 10 and FIG. 21, an orthographic projection of the auxiliary trace L3 and the second sub-signal line L12 on the base substrate may not be overlapped with an orthographic projection of the anode 140 of the second light emitting element 14 on the base substrate. The second sub-signal line L12 and the auxiliary trace L3 may extend along a gap between anodes 140 of adjacent second light emitting elements.

Subsequently, a pixel definition thin film is coated, and a pixel definition layer is formed through masking, exposure, and development processes. The pixel definition layer may be formed with a plurality of pixel openings exposing the anode layer. In some examples, as shown in FIG. 8, the pixel definition layer of the first display region may form a first pixel opening OP1 exposing a portion of a surface of the anode 120 of the first light emitting element 12. As shown in FIG. 10, the pixel definition layer of the second display region may form a second pixel opening OP2 exposing a portion of a surface of the anode 140 of the second light emitting element 14.

In some examples, an organic emitting layer is formed within a pixel opening formed above, and the organic emitting layer is connected with the anode layer. Subsequently, a cathode thin film is deposited, and the cathode thin film is patterned through a patterning process to form a pattern of a cathode, and the cathode is connected with the organic emitting layer. Then, an encapsulation layer is formed on the cathode. The encapsulation layer may include a laminated structure of an inorganic material/an organic material/an inorganic material.

In some examples, the first conductive layer 202, the second conductive layer 203, the third conductive layer 204, and the fourth conductive layer 206 may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure, or a multi-layer composite structure, such as Mo/Cu/Mo. The transparent conductive layer 205 may be made of a transparent conductive material, for example, Indium Tin Oxide (ITO) or the like. The first insulation layer 101, the second insulation layer 102, and the third insulation layer 103 may be any one or more of Silicon Oxide (SiOx), Silicon Nitride (SiNx), and Silicon Oxynitride (SiON), and may be a single layer, a multi-layer, or a composite layer. The fourth insulation 104, the fifth insulation layer 105, and the sixth insulation layer 106 may be made of an organic material, such as polyimide, acrylic, or polyethylene terephthalate. The pixel definition layer 304 may be made of an organic material, such as polyimide, acrylic, or polyethylene terephthalate. The anode layer 301 may be made of a reflective material such as a metal, and the cathode layer 303 may be made of a transparent conductive material. However, this embodiment is not limited thereto.

The structure and the preparation process of the display substrate of this embodiment are merely illustrative. In some exemplary Implementation modes, a corresponding structure may be changed and a patterning process may be increased or decreased according to actual needs. The preparation process of this exemplary embodiment may be achieved using an existing mature preparation device, and may be compatible well with an existing preparation process, simple in process achievement, easy to implement, high in a production efficiency, low in a production cost, and high in a yield.

In other examples, the first signal line may further include a light emitting control line and a first reset control line. A winding mode of the light emitting control line and the first reset control line, and a connection manner between sub-signal lines are similar to a winding mode and a connection manner of scan lines, and thus will not be repeated here.

According to the display substrate provided by this example, a load of a scan signal of the first display region may be reduced by setting a scan line to include a first sub-signal line and a second sub-signal line connected in parallel and electrically, which is beneficial to improving lateral display mura on left and right sides of the first display region, and may improve display uniformity of the display substrate.

FIG. 23 is a partial schematic diagram of a second signal line of a display substrate according to at least one embodiment of the present disclosure. In some examples, as shown in FIG. 23, the display substrate may include a plurality of second signal lines L2. A second signal line L2 may provide a second signal in the second direction Y to a second pixel circuit within the first display region A1. For example, the second signal line L2 may include at least one of following: a data line and a first power supply line.

In some examples, as shown in FIG. 23, the second signal line L2 may include a fifth sub-signal line L21, a sixth sub-signal line L22, a seventh sub-signal line L23, and an eighth sub-signal line L24. The seventh sub-signal line L23 and the eighth sub-signal line L24 may both extend along the second direction Y, and are located within the second display region on opposite sides of the first display region A1 along the second direction Y. The fifth sub-signal line L21 may be located within the first display region A1 and extend along the second direction Y. Both ends of the fifth sub-signal line L21 may be electrically connected with the seventh sub-signal line L23 and the eighth sub-signal line L24, respectively. The sixth sub-signal line L22 may be located within the second display region. The sixth sub-signal line L22 may bypass the first display region A1, and both ends of the sixth sub-signal line L22 may be electrically connected with the seventh sub-signal line L23 and the eighth sub-signal line L24, respectively. For example, the sixth sub-signal line L22 may extend along the first direction X, then extend along the second direction Y, and then extend along the first direction X. The fifth sub-signal line L21 and the sixth sub-signal line L22 of the second signal line L2 are connected in parallel and electrically, and are connected in series with the seventh sub-signal line L23 and the eighth sub-signal line L24.

Taking a case in which the second signal line L2 is a data line as an example, the data connection line 45 in the aforementioned embodiment may be the fifth sub-signal line L21 located within the first display region, and in the second display region a sixth sub-signal line L22 connected in parallel and electrically with the data connection line 45 may also be included. The fifth sub-signal line L21 may be located in the transparent conductive layer, and the sixth sub-signal line L22 may be the fourth conductive layer. However, this embodiment is not limited thereto.

In some examples, as shown in FIG. 23, the plurality of second signal lines L2 may be divided into two groups.

For example, a first group of second signal lines and a second group of second signal lines may be substantially symmetrical with respect to a second center line O2 of the first display region A1 along the first direction X. A quantity of second signal lines in the first group of second signal lines and a quantity of second signal lines in the second group of second signal lines may be substantially the same. A sixth sub-signal line L22 of a second signal line L2 in the first group of second signal lines may be located within the second display region on one side of the first display region A1 along the first direction X, and a sixth sub-signal line L22 of a second signal line L2 in the second group of second signal lines may be located within the second display region on the other side of the first display region A1 along the first direction X. For example, the sixth sub-signal line L22 of the first group of second signal lines may bypass the first display region A1 from a left side of the first display region A1, and the sixth sub-signal line L22 of the second group of second signal lines may bypass the first display region A1 from a right side of the first display region A1. In this way, trace aggregation may be avoided, which affects a display effect.

In some examples, as shown in FIG. 23, a sixth sub-signal line L22 of a second signal line L2 close to an edge of the first display region A1 in the first direction X may be located on a side of a sixth sub-signal line L22 of a second signal line L2, which is close to the second center line O2 of the first display region A1 along the first direction X, close to the first display region A1. In other words, a length of the sixth sub-signal line L22 of the second signal line L2, which is close to the second center line O2 of the first display region A1 along the first direction X, along the first direction X may be larger than a length of the sixth sub-signal line L22 of the second signal line L2, which is close to the edge of the first display region A1, along the first direction X. In this way, overlapping of traces may be reduced, which is beneficial to a rational arrangement of sixth sub-signal lines.

In some examples, as shown in FIG. 23, a second signal may be transmitted within the first display region A1 through the fifth sub-signal line L21, and may also be transmitted within the second display region through the sixth sub-signal line L22. In this example, a transmission load of the second signal of the first display region A1 may be reduced by setting the fifth sub-signal line L21 and the sixth sub-signal line L22 in parallel and electrically connected to transmit the second signal, thereby improving vertical display mura existing in the second display regions on upper and lower sides of the first display region A1.

For other description of this embodiment, reference may be made to description of the aforementioned embodiments, so details will not be repeated here.

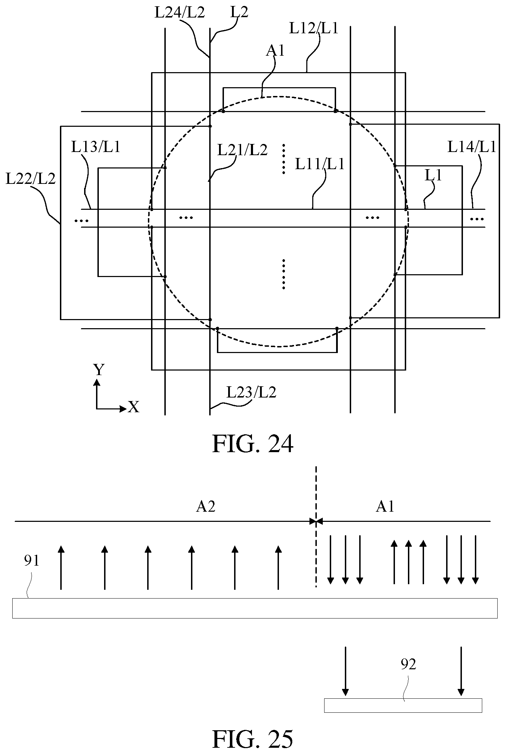

FIG. 24 is a partial schematic diagram of a first signal line and a second signal line of a display substrate according to at least one embodiment of the present disclosure. In some examples, as shown in FIG. 24, the display substrate may include a plurality of first signal lines L1 and a plurality of second signal lines L2. A first signal line L1 may include a first sub-signal line L11 and a second sub-signal line L12 connected in parallel and electrically, and a second signal line L2 may include a fifth sub-signal line L21 and a sixth sub-signal line L22 connected in parallel and electrically. The first sub-signal line L11 and the fifth sub-signal line L21 may be located in the first display region A1, and the second sub-signal line L12 and the sixth sub-signal line L22 may be located in the second display region A2.

In some examples, the first sub-signal line L11 and the fifth sub-signal line L21 may be located in the transparent conductive layer. The second sub-signal line L12 and the sixth sub-signal line L22 may be located in a same film layer, for example, may be located in the fourth conductive layer, thereby saving a preparation process. In other examples, the second sub-signal line L12 and the sixth sub-signal line L22 may be located in different film layers. For example, the second sub-signal line L12 may be located in the fourth conductive layer, and the sixth sub-signal line L22 may be located in the fifth conductive layer on a side of the fourth conductive layer away from the base substrate, thereby avoiding trace intersecting.

In some examples, the display substrate may further include a first auxiliary trace disposed in a same layer as the second sub-signal line, and a second auxiliary trace disposed in a same layer as the sixth sub-signal line. A form of the first auxiliary trace may be similar to that of the second sub-signal line, and a form of the second auxiliary trace may be similar to that of the sixth sub-signal line, thereby achieving wiring and display uniformity of a display region.

Rest of the structure of the display substrate according to this embodiment may be referred to description of the aforementioned embodiments, and thus will not be repeated here.

At least one embodiment of the present disclosure also provides a display apparatus which includes the display substrate as described above.

FIG. 25 is a schematic diagram of a display apparatus according to at least one embodiment of the present disclosure. As shown in FIG. 25, this embodiment provides a display apparatus, which includes a display substrate 91 and a photosensitive sensor 92 located on a light exiting side of a display structure layer away from the display substrate 91. An orthographic projection of the photosensitive sensor 92 on the display substrate 91 is overlapped with an orthographic projection of a first display region A1.

In some examples, the display substrate 91 may be a flexible OLED display substrate, a QLED display substrate, a Micro-LED display substrate, or a Mini-LED display substrate. The display apparatus may be any product or component with a display function such as an OLED display, a cell phone, a tablet, a television, a display, a laptop, a digital photo frame, and a navigator, and the embodiment of the present disclosure is not limited thereto.

The drawings of the present disclosure only involve structures involved in the present disclosure, and other structures may be referred to conventional designs. The embodiments of the present disclosure, i.e., features in the embodiments, may be combined with each other to obtain new embodiments if there is no conflict. Those of ordinary skills in the art should understand that modifications or equivalent replacements may be made on the technical solutions of the present disclosure without departing from the spirit and scope of the technical solutions of the present disclosure, and shall all fall within the scope of the claims of the present disclosure.

**Claims**

1. A display substrate, comprising:

   a base substrate, comprising a first display region and a second display region located on least one side of the first display region;
   a plurality of first pixel circuits and a plurality of first light emitting elements, located in the first display region; wherein at least one first pixel circuit among the plurality of first pixel circuits is electrically connected with at least one first light emitting element among the plurality of first light emitting elements, and is configured to drive the at least one first light emitting element to emit light; and
   at least one first signal line configured to provide a first signal to the plurality of first pixel circuits in a first direction; wherein the at least one first signal line comprises a first sub-signal line and a second sub-signal line connected in parallel and electrically, the first sub-signal line is located in the first display region, and the second sub-signal line is located in the second display region.

2. The display substrate according to claim 1, wherein the first sub-signal line is made of a transparent conductive material and the second sub-signal line is made of a metal material.

3. The display substrate according to claim 1 or 2, wherein the second sub-signal line is located on a side of the first sub-signal line away from the base substrate.

4. The display substrate according to any one of claims 1 to 3, wherein the at least one first signal line further comprises: a third sub-signal line and a fourth sub-signal line located in the second display region, wherein the third sub-signal line and the fourth sub-signal line are located in the second display region on opposite sides of the first display region along the first direction; and
   both ends of the first sub-signal line are electrically connected with the third sub-signal line and the fourth sub-signal line, respectively, and both ends of the second sub-signal line are electrically connected with the third sub-signal line and the fourth sub-signal line, respectively.

5. The display substrate according to claim 4, wherein at least one end of the first sub-signal line is electrically connected with the third sub-signal line or the fourth sub-signal line through a gate of a transistor of at least one first pixel circuit.

6. The display substrate according to any one of claims 1 to 5, wherein the display substrate comprises a plurality of first signal lines which are divided into two groups; a second sub-signal line of a first group of first signal lines is located within the second display region on one side of the first display region along a second direction, and a second sub-signal line of a second group of first signal lines is located within the second display region on the other side of the first display region along the second direction, and the second direction intersects with the first direction.

7. The display substrate according to any one of claims 1 to 6, further comprising: a plurality of second pixel circuits and a plurality of second light emitting elements located in the second display region, wherein at least one second pixel circuit among the plurality of second pixel circuits is electrically connected with at least one second light emitting element among the plurality of second light emitting elements, and is configured to drive the at least one second light emitting element to emit light; and
   an orthographic projection of a second sub-signal line of the at least one first signal line on the base substrate is not overlapped with an orthographic projection of an anode of the second light emitting element on the base substrate.

8. The display substrate according to claim 7, wherein the second pixel circuit at least comprises: a drive transistor, a threshold compensation transistor, and a storage capacitor; a gate of the drive transistor is electrically connected with a first electrode plate of the storage capacitor and a first electrode of the threshold compensation transistor; and an orthographic projection of the second sub-signal line of the at least one first signal line on base substrate is not overlapped with an orthographic projection of a connection position of the gate of the drive transistor, the first electrode of the threshold compensation transistor, and the first electrode plate of the storage capacitor of the second pixel circuit on the base substrate.

9. The display substrate according to claim 7 or 8, wherein the second sub-signal line comprises: a first connection segment, a second connection segment, a third connection segment, and a fourth connection segment; the second connection segment is a straight line segment extending along the first direction, the second connection segment is electrically connected with the first connection segment, and the first connection segment is configured to at least partially surround an anode of one second light emitting element; the third connection segment is a fold line extending along a second direction, the fourth connection segment is connected with the third connection segment, and the fourth connection segment is a straight line segment extending along the first direction; and the second direction intersects with the first direction.

10. The display substrate according to claim 8, wherein the second display region is further provided with a plurality of auxiliary traces disposed in a same layer as the second sub-signal line, wherein an orthographic projection of the plurality of auxiliary traces on the base substrate is not overlapped with the orthographic projection of the anode of the second light emitting element or the orthographic projection of the connection position of the gate of the drive transistor, the first electrode of the threshold compensation transistor, and the first electrode plate of the storage capacitor of the second pixel circuit on the base substrate.

11. The display substrate according to claim 10, wherein the auxiliary traces are configured to be electrically connected with a first power supply line.

12. The display substrate according to claim 10 or 11, wherein at least one of the plurality of auxiliary traces comprises: a first auxiliary segment and a second auxiliary segment which are connected with each other; and the first auxiliary segment is a straight line segment extending along the first direction, and the second auxiliary segment is a fold line extending along a second direction, and the second direction intersects with the first direction.

13. The display substrate according to any one of claims 1 to 12, wherein the at least first signal line comprises at least one of following: a scan line, a first reset control line, and a light emitting control line.

14. The display substrate according to any one of claims 1 to 13, further comprising: at least one second signal line configured to provide a second signal to the plurality of first pixel circuits in a second direction; the at least one second signal line comprises a fifth sub-signal line and a sixth sub-signal line connected in parallel and electrically, wherein the fifth sub-signal line is located in the first display region and the sixth sub-signal line is located in the second display region; and the first direction intersects with the second direction.

15. The display substrate according to claim 14, wherein the first direction is perpendicular to the second direction.

16. The display substrate according to claim 14 or 15, wherein the at least one second signal line further comprises: a seventh sub-signal line and an eighth sub-signal line located in the second display region, wherein the seventh sub-signal line and the eighth sub-signal line are located within the second display region on opposite sides of the first display region along the second direction; and both ends of the fifth sub-signal line are electrically connected with the seventh sub-signal line and the eighth sub-signal line, respectively, and both ends of the sixth sub-signal line are electrically connected with the seventh sub-signal line and the eighth sub-signal line, respectively.

17. The display substrate according to any one of claims 14 to 16, wherein the fifth sub-signal line is disposed in a same layer as the first sub-signal line, and the sixth sub-signal line and the second sub-signal line are located in different film layers.

18. The display substrate according to any one of claims 1 to 17, wherein a pixel density of the first display region is less than or equal to a pixel density of the second display region.

19. The display substrate according to any one of claims 1 to 18, wherein a light transmittance rate of the first display region is greater than a light transmittance rate of the second display region.

20. A display apparatus, comprising a display substrate according to any one of claims 1 to 19.

FIG. 1

FIG. 2

FIG. 3

FIG. 4

FIG. 5

EP 4 336 480 A1

FIG. 6

FIG. 7

FIG. 8

FIG. 9

FIG. 10

FIG. 11

FIG. 12A

FIG. 12B

FIG. 12C

FIG. 13A

FIG. 13B

RST1(n)

GL(n)

EML(n)

RST1(n+1)

GL(n+1)

EML(n+1)

FIG. 13C

FIG. 14A

FIG. 14B

FIG. 14C

FIG. 15A

FIG. 15B

A2    A1

V17

V18

Y
X

FIG. 15C

401  408  291
403  292  402
295  405
404
406  407
293  294

Y
X

FIG. 16A

FIG. 16B

FIG. 16C

FIG. 17A

FIG. 17B

FIG. 18A

FIG. 18B

V51

V52 V53

Y
X

FIG. 19A

V54

Y
X

V55

FIG. 19B

FIG. 19C

FIG. 20A

L32/L3　　　L12　　　L123/L12　　　L12

423

Y
└→X

## FIG. 20B

L31/L3　　　　　L124/L12

L3　　　L3　　　L12　　　L12　　　L12

140

OP2

V62

423

Y
└→X

## FIG. 21

FIG. 22

FIG. 23

L24/L2    L2

L12/L1

A1

L13/L1          L21/L2    ⋮    L11/L1

L14/L1

L22/L2                        ⋮              L1

⋯          ⋯        ⋯          ⋯

⋮

Y

⋮

X                    L23/L2

## FIG. 24

A2          A1

91

92

## FIG. 25

## INTERNATIONAL SEARCH REPORT

| International application No. |
| --- |
| **PCT/CN2022/124814** |

**A. CLASSIFICATION OF SUBJECT MATTER**

G09F 9/33(2006.01)i

According to International Patent Classification (IPC) or to both national classification and IPC

**B. FIELDS SEARCHED**

Minimum documentation searched (classification system followed by classification symbols)

G09F

Documentation searched other than minimum documentation to the extent that such documents are included in the fields searched

Electronic data base consulted during the international search (name of data base and, where practicable, search terms used)

CNPAT, WPI, CNKI, IEEE: 阵列基板, 透明, 透光, 显示, 第二子数据线, ITO, 第一子信号线, 电抗, 刷新率, 不透光, 并联, 虚拟, 辅助, 第二子信号线, 不透明, 第一子数据线, tft阵列, 薄膜晶体管阵列, 冗余, 电阻, 补偿, 阻抗, 非透光, 虚设, 非透明, 金属, transparent, display, auxiliary, impedance, resistance, signal line, compensate

**C. DOCUMENTS CONSIDERED TO BE RELEVANT**

| Category* | Citation of document, with indication, where appropriate, of the relevant passages | Relevant to claim No. |
| --- | --- | --- |
| X | CN 111048004 A (WUHAN TIANMA MICRO-ELECTRONICS CO., LTD.) 21 April 2020 (2020-04-21) <br> description paragraphs 37-78, and figures 1-3 and 6 | 1-20 |
| A | CN 113327517 A (KUNSHAN GOVISIONOX OPTOELECTRONICS CO., LTD.) 31 August 2021 (2021-08-31) <br> entire document | 1-20 |
| A | CN 113421906 A (BOE TECHNOLOGY GROUP CO., LTD. et al.) 21 September 2021 (2021-09-21) <br> entire document | 1-20 |
| A | US 2020320959 A1 (SAMSUNG DISPLAY CO., LTD.) 08 October 2020 (2020-10-08) <br> entire document | 1-20 |
| A | CN 113128423 A (AU OPTRONICS CORPORATION) 16 July 2021 (2021-07-16) <br> entire document | 1-20 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **12 December 2022** | **21 December 2022** |

| Name and mailing address of the ISA/CN | Authorized officer |
| --- | --- |
| **China National Intellectual Property Administration (ISA/ CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/124814**

| Patent document cited in search report | | | Publication date (day/month/year) | Patent family member(s) | | | Publication date (day/month/year) |
|---|---|---|---|---|---|---|---|
| CN | 111048004 | A | 21 April 2020 | None | | | |
| CN | 113327517 | A | 31 August 2021 | None | | | |
| CN | 113421906 | A | 21 September 2021 | None | | | |
| US | 2020320959 | A1 | 08 October 2020 | KR | 20200118285 | A | 15 October 2020 |
| | | | | CN | 111798793 | A | 20 October 2020 |
| CN | 113128423 | A | 16 July 2021 | None | | | |

Form PCT/ISA/210 (patent family annex) (January 2015)

**REFERENCES CITED IN THE DESCRIPTION**

**Patent documents cited in the description**

- CN 202111221399